# EUROPEAN PATENT APPLICATION

(11) **EP 1 582 932 A2**
(43) Date of publication of application: **05.10.2005**
(21) Application number: 05251985.7
(22) Date of filing: 30.03.2005
(51) Int. Cl.: G03F 7/20

(54) **Alignment apparatus, exposure apparatus, and device manufacturing method**

(30) Priority: 31.03.2004 JP 2004106245
(71) Applicant: CANON KABUSHIKI KAISHA, Tokyo (JP)
(72) Inventor: Kimura, Atsushi, Ohta-ku Tokyo (JP); Korenaga, Nobushige, Ohta-ku Tokyo (JP); Kubo, Hiroyoshi, Ohta-ku Tokyo (JP)
(74) Representative: Beresford, Keith Denis Lewis

(57) **Abstract**

In an alignment apparatus having two movable elements (11a,11b) which move on a stator (2) having a planer portion, the two movable elements are prevented from moving to deviate from target position while enabling the two movable elements to swap. The alignment apparatus includes a stator which has a planer portion including first and second areas, first and second movable elements which move on the planer portion, and a regulating mechanism which regulates positions of the first and second movable elements. The first and second movable elements are driven to target positions by the Lorentz force that acts with respect to the stator. The regulating mechanism includes a first regulator (111a) which regulates the position of the movable element (11a) which is located in the first area such that the movable element will not deviate from the target position, and a second regulator (112b) which regulates the position of the movable element (11b) which is located in the second area such that the movable element will not deviate from the target position.

## Description

### FIELD OF THE INVENTION

The present invention relates to an alignment apparatus having two movable elements which move on a plane, an exposure apparatus to which the alignment apparatus is applied, and a device manufacturing method which uses the exposure apparatus.

### BACKGROUND OF THE INVENTION

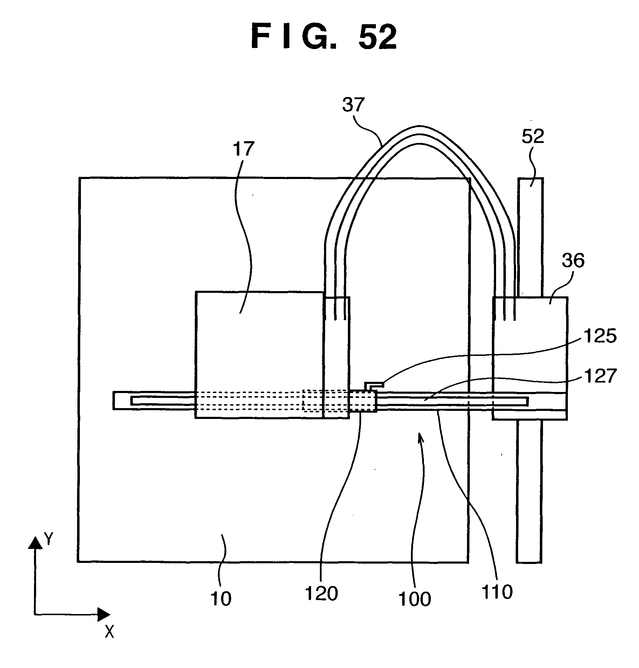

Fig. 52 is a plan view of a stage device disclosed in Japanese Patent Laid-Open No. 2003-257851. This stage device has a planer motor including a stator 10 having stationary magnets (not shown) and a movable element 17 having movable coils (not shown). The movable element 17 moves in X and Y directions within a plane on the stator 10. The movable element 17 can rotate with respect to the stator 10 because no guide is provided. If the amount of rotation of the movable element 17 increases, the movable element 17 goes out of control. For this reason, a mechanism that prevents rotation of the movable element 17 is necessary.

An anti-rotation mechanism or rotation prevention mechanism 100 has an actuator 36 which moves in the Y direction along a guide 52 and a bar 110 which is attached to the support bar 36. A sleeve 120 which is arranged to partially surround the bar 110 is attached to the movable element 17. The sleeve 120 can slide along the bar 110.

With this structure, when the movable element 17 moves in the X direction, the sleeve 120 slides along the bar 110. When the movable element 17 moves in the Y direction, the actuator 36 also moves in the Y direction by a corresponding amount. Thus, the movable element 17 can move freely without being interfered with by the anti-rotation mechanism 100. Even if the movable element 17 is to rotate about the Z-axis, it cannot rotate because the two ends of the sleeve 120 are in contact with the bar 110.

Cables 37 for supplying power to the coils or the like of the movable element 17 are provided between the movable element 17 and actuator 36. When the movable element 17 moves in the Y direction, the actuator 36 also moves accordingly. Thus, the loop shapes of the cables 37 do not change, and the movable element 17 receives no load change from the cables 37. The anti-rotation mechanism 100 is provided with encoders 125 and 127 which are used for alignment adjustment of the movable element 17 and the like.

In recent years, as a wafer stage device used in a semiconductor exposure apparatus, one with a scheme which has twin stages, i.e., two stages, has been proposed. One stage is used for exposure and the other stage is used for alignment. When exposure for one wafer is ended, the two stages are swapped. With this scheme, since exposure and alignment can be performed in a parallel manner, the throughput is improved when compared to a conventional single stage device. When, however, the stage having the structure shown in Fig. 52 is to be applied to twin stages, swapping cannot be performed because of the presence of the anti-rotation mechanism 100.

### SUMMARY OF THE INVENTION

An embodiment of the present invention seeks to prevent, for example, in an alignment apparatus having two movable elements which move on a stator having a planer portion, the two movable elements from moving to deviate from target positions while enabling swap of the two movable elements.

An alignment apparatus according to an embodiment comprises a stator which has a planer portion including first and second areas, first and second movable elements which move on the planer portion, and a regulating mechanism which regulates positions of the first and second movable elements. The first and second movable elements are driven to target positions by a force that acts among the first and second movable elements and stator. The regulating mechanism includes a first regulator which regulates the position of, of the first and second movable elements, one which is located in the first area such that the movable element will not deviate from the target position, and a second regulator which regulates the position of, of the first and second movable elements, one which is located in the second area such that the movable element will not deviate from the target position.

According to a preferred embodiment of the present invention, the first and second areas can partially overlap.

According to another preferred embodiment of the present invention, preferably, the first and second regulators do not come into contact with the first and second movable elements while the first and second movable elements are located at the target positions.

According to still another preferred embodiment of the present invention, preferably, the first and second movable elements respectively include engaging portions, and deviation of the movable elements from the target positions is regulated by contact of the first or second regulator and the engaging portions.

According to still another preferred embodiment of the present invention, preferably, the regulating mechanism includes a driving mechanism which moves the engaging portions and/or the first and second regulators when the first and second movable elements are to be swapped between the first and second areas.

According to still another preferred embodiment of the present invention, the first and second movable elements can respectively include at least first and second engaging portions, the position of the movable element which has been driven from the second area to the first area can be regulated by the first engaging portion and first regulator, and the position of the movable element which has been driven from the first area to the second area can be regulated by the second engaging portion and second regulator.

According to still another preferred embodiment of the present invention, the engaging portions can include recesses, ridges, or holes.

According to still another preferred embodiment of the present invention, the first regulator can be provided to a first support moving member which moves together with, of the first and second movable elements, one which is located in the first area, and the second regulator can be provided to a second support moving member which moves together with, of the first and second movable elements, one which is located in the second area. The first and second support moving members can move in such directions that a distance between the first and second support moving members changes. The first and second regulators extend along, e.g., longitudinal directions of the first and second support moving members, respectively, and the first and second support moving members stop when, e.g., the first and second movable elements move along the longitudinal directions, and move in the longitudinal directions, when the first and second movable elements move along directions perpendicular to the longitudinal directions, together with the first and second movable elements. Alternatively, the first regulator may move in the longitudinal direction of the first support moving member together with the movable element located in the first area, and the second regulator may move along the longitudinal direction of the second support moving member together with the movable element located in the second area.

According to still another preferred embodiment of the present invention, preferably, the first and second support moving members have stoppers which regulate moving ranges of the first and second movable elements in the longitudinal directions.

According to still another preferred embodiment of the present invention, preferably, the alignment apparatus comprises a second stopper which regulates moving ranges of the first and second support moving members.

According to still another preferred embodiment of the present invention, preferably, the alignment apparatus further comprises a first support moving member which is arranged to extend along a second direction perpendicular to a first direction and moves along the first direction together with, of the first and second movable elements, one which is located in the first area, a second support moving member which is arranged to extend along the second direction and moves together with, of the first and second movable elements, one which is located in the second area, a first fixed member which is arranged within the first area so as to extend along the first direction between the first and second support moving members, and a second fixed member which is arranged within the second area so as to extend along the first direction between the first and second support moving members. The first regulator can be provided to the first support moving member and first fixed member to regulate the position of the movable element in the first area, and the second regulator can be provided to the second support moving member and second fixed member to regulate the position of the movable element in the second area.

According to still another preferred embodiment of the present invention, preferably, a portion through which the first and second regulators and the engaging portions can be in contact with each other is formed such that when the engaging portions come into contact with the first and second regulators, the engaging portions slide on the first and second regulators.

According to still another preferred embodiment of the present invention, preferably, the first and second regulators and the engaging portions come into contact with each other through rollers.

According to still another preferred embodiment of the present invention, preferably, each of the first and second regulators is divided into a plurality of pieces, and the plurality of divisional pieces are driven independently of each other.

According to still another preferred embodiment of the present invention, preferably, the first and second regulators and the first and second movable elements are formed such that even when a power supply is turned off, the positions of the first and second movable elements are regulated by the first and second regulators.

According to still another preferred embodiment of the present invention, preferably, at least one of the first and second movable elements has an identifying unit for identifying the remaining one of the first and second movable elements.

According to still another preferred embodiment of the present invention, preferably, the alignment apparatus further comprises a sensor which checks that the positions of the first and second movable elements are regulated by the first and second regulators.

According to still another preferred embodiment of the present invention, preferably, in a first step, the first and second movable elements arranged on a line along a first direction are moved in opposite directions along a second direction perpendicular to the first direction, subsequently, in a second step, the first and second movable elements are moved in opposite directions along the first direction, and subsequently, in a third step, the first and second movable elements are moved in the opposite directions along the second direction so that the first and second movable elements are arranged on the line again, thereby swapping the first and second movable elements.

According to still another preferred embodiment of the present invention, preferably, the alignment apparatus further comprises first and second support moving members which extend in the second direction and oppose each other, the first and second regulators being provided to the first and second support moving members, respectively, wherein in the first step, while the first and second support moving members are set still, the first and second movable elements are moved along the second direction while regulating the positions of the first and second movable elements by the first and second regulators, in the second step, the first and second support moving members are moved along the first direction and the first and second movable elements are moved along the second direction while regulating the positions of the first and second movable elements by the first and second regulators, and in the third step, while the first and second support moving members are set still, the first and second movable elements are moved along the second direction while regulating the positions of the first and second movable elements by the first and second regulators. In the second step, the first and second movable elements are moved along the first direction to positions where the first and second movable elements are arranged on a line along the second direction, and when the second step is to shift to the third step, the first and second regulators that are to regulate the positions of the first and second movable elements can be swapped.

According to still another preferred embodiment of the present invention, the alignment apparatus further comprises first and second support moving members which extend in the second direction and oppose each other, and first and second fixed members arranged between the first and second support moving members along the first direction, wherein the first regulator can be provided to the first support moving member and first fixed member, and the second regulator can be provided to the second support moving member and second fixed member. In the first step, while the first and second support moving members are set still, the first and second movable elements can be moved along the second direction while regulating the positions of the first and second movable elements by the first and second regulators provided to the first and second support moving members, in the second step, the first and second support moving members can be moved along the first direction, the first and second movable elements can be moved along the first direction while regulating the positions of the first and second movable elements by the first and second regulators provided to the first and second support moving members, thereafter the first and second moving members can be set still, and the first and second movable elements can be moved along the first direction while regulating the positions of the first and second movable elements by the first and second regulators provided to the first and second fixed members, and in the third step, while the first and second support moving members are set still, the first and second movable elements can be moved along the second direction while regulating the positions of the first and second movable elements by the first and second regulators provided to the first and second support moving members.

An exposure apparatus according to an embodiment is directed to an exposure apparatus for forming a latent image of a pattern on a photo sensitive agent on a substrate to which the photo sensitive agent has been applied. The exposure apparatus comprises the above alignment apparatus which has first and second stages and holds and aligns substrates on the first and second stages, and a pattern forming unit which forms a latent image pattern on the photo sensitive agent on the substrate held on, of the first and second stages, one which is located within an exposure process area, the first and second movable elements including the first and second stages, respectively.

A device manufacturing method according to an embodiment comprises a step of forming, by using the above exposure apparatus, a latent image on a photo sensitive agent on a substrate to which the photo sensitive agent has been applied, and a step of developing the latent image pattern.

According to an embodiment, for example, in an alignment apparatus having two movable elements which move on a stator having a planer portion, the two movable elements can be prevented from moving to deviate from target positions while enabling swap of the two movable elements.

Optional features of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention.
Figs. 1A to 6B are schematic views showing a twin stage device according to the first embodiment of the present invention;
Fig. 7 is an exploded perspective view showing an example of a movable element and support bar in Figs. 1A and 1B;
Fig. 8 is a view showing an example of the recess (engaging portion) of an anti-rotation member and the ridge (regulating portion) of a support bar in Figs. 1A and 1B;
Fig. 9 is a view showing another example of the recess (engaging portion) of the anti-rotation member and the ridge (regulating portion) of the support bar in Figs. 1A and 1B;
Figs. 10A to 15B are schematic views showing a twin stage device according to the second embodiment of the present invention;
Fig. 16 is a view showing an example of the recess (engaging portion) of an anti-rotation member and the ridge (regulating portion) of a support bar in Figs. 10A and 10B;
Figs. 17 to 24 are schematic views showing a twin stage device according to the third embodiment of the present invention;
Fig. 25 is a view showing an example of the recess (engaging portion) of an anti-rotation member and the ridge (regulating portion) of a support bar in Fig. 17;
Figs. 26 to 32 are schematic views showing a twin stage device according to the fourth embodiment of the present invention;
Figs. 33 to 42 are schematic views showing a twin stage device according to the fifth embodiment of the present invention;
Figs. 43 to 47 are schematic views showing a twin stage device according to the sixth embodiment of the present invention;
Figs. 48 to 51 are schematic views showing the twin stage device according to the sixth embodiment of the present invention;
Fig. 52 is a schematic plan view of a conventional stage device;
Fig. 53 is a view showing the schematic structure of an exposure apparatus;
Fig. 54 is a flowchart showing a device manufacturing method; and
Fig. 55 is a flowchart showing the device manufacturing method.

### DETAILED DESCRIPTION OF THE PREFERRED EMBODIMENTS

The preferred embodiments of the present invention will be described with reference to the accompanying drawings.

### (First Embodiment)

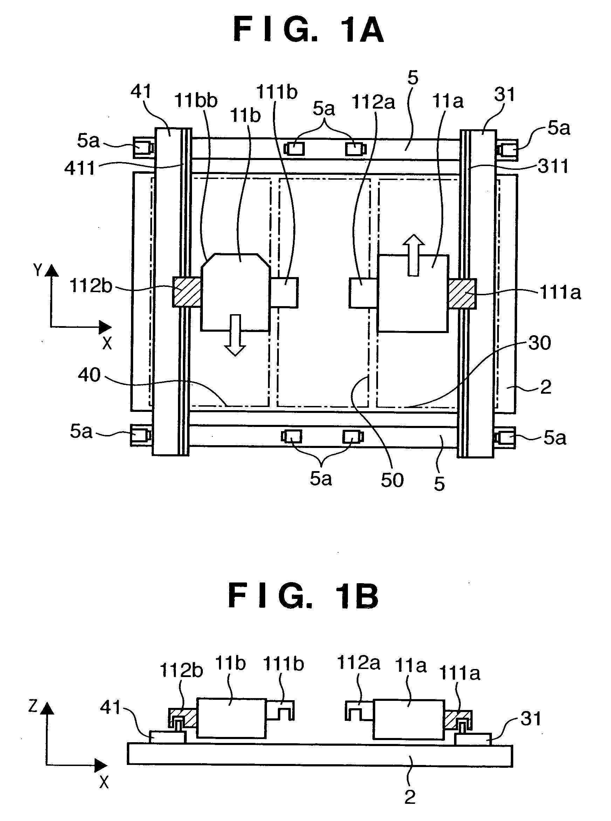

Figs. 1A to 6B are schematic views of a wafer stage device according to the first embodiment of the present invention. Of Figs. 1A to 6B, Figs. 1A, 2A, 3A, 4A, 5A, and 6A are plan views and Figs. 1B, 2B, 3B, 4B, 5B, and 6B are side views. Figs. 1A to 6B show the movement of the stages at different steps sequentially.

The structure of the wafer stage device as an alignment apparatus will be described with reference to Figs. 1A and 1B. The wafer stage device has a twin stage arrangement including two stages (tables). More specifically, the wafer stage device has a stator 2 including fixed coils (not shown) and having a planer portion, and two movable elements 11a and 11b including movable magnets (not shown) which move on the planer potion. The two movable elements 11a and 11B respectively include stages (tables) 11a and 11b which can hold wafers, respectively. The stator 2 and movable element 11a form one planer motor, and the stator 2 and movable element 11b form the other planer motor. The planer motors drive the movable elements 11a and 11b to target positions (or drive them along target trajectories) by the Lorentz force. According to the characteristic feature of the present invention, each planer motor has a simple structure as opposed to an arrangement in which a movable element is two-dimensionally driven by a two-axis linear motor. The planer motors are not limited to those utilizing the Lorentz force but can be formed by other schemes, e.g., a linear pulse motor which uses a variable magnetoresistance (magnetic attracting force).

The moving areas of the movable elements 11a and 11b on the stator 2 include an exposure process area 30, an alignment process area 40, and a swap process area 50 sandwiched by the exposure process area 30 and alignment process area 40. The two movable elements 11a and 11b can come and go to and from the exposure process area 30 and alignment process area 40 through the swap process area 50.

Bar mirrors (not shown) are mounted on the two movable elements 11a and 11b. The positions of the bar mirrors are measured by interferometers. The movable elements 11a and 11b are driven to the target positions on the basis of the measurement results. Anti-rotation member or rotation prevention member (from another point of view, abnormal movement prevention member,; this applies to the following description) 111a and 112a and 111b and 112b are arranged on the side surfaces of the movable elements 11a and 11b. The anti-rotation members 111a and 112a, and 111b and 112b have recesses (engaging portions) and can be vertically moved independently of each other with respect to the movable elements 11a and 11b. Support bars (support moving members) 31 and 41 are arranged such that they can be moved by a driving mechanism (not shown) in the X direction along guides 5. With the driving mechanism, for example, magnets can be provided to the support bars 31 and 41, and the support bars 31 and 41 can be driven by the interaction (Lorentz force) with the stator 2. The support bars 31 and 41 respectively have ridges (regulating portions) 311 and 411, and can respectively engage with the recesses of the anti-rotation members 111a and 112a of the movable elements 11a and 11b in a noncontact manner. Engagement in a noncontact manner means the following positional relationship. Namely, when the movable elements 11a and 11b move to deviate from the target positions (regular positions) (this movement can be caused by, e.g., rotation, uncontrollable run, or the like), the engaging portions (in this case, the recesses of the anti-rotation members) and the regulating portions (in this case, the ridges formed on the support bars) come into contact with each other. When the movable elements 11a and 11b are located within the allowable ranges of the target positions, the engaging portions and regulating portions are not in contact with each other.

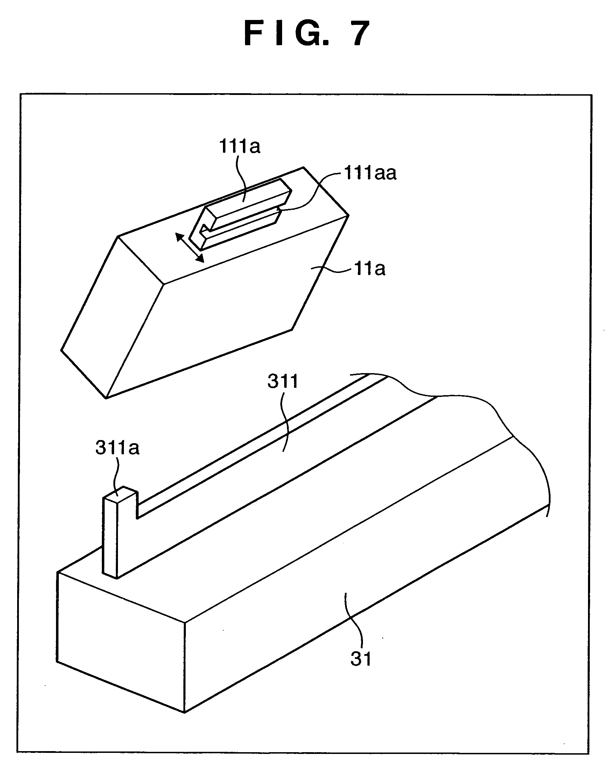

For example, as shown in the exploded perspective view of Fig. 7, the anti-rotation member 111a moves vertically with respect to the movable element 11a. Thus, when necessary, a recess 111aa of the anti-rotation member 111a engages with the ridge 311 of the support bar 31 in a noncontact manner. The position of the support bar is measured by an interferometer and controlled, so that it can move in synchronism with the movable element while maintaining the non-contact state of the recess (engaging portion) and ridge (regulating portion). Usually, when the movable element 11a moves in the X direction, the support bar 31 also moves in the X direction by a corresponding amount, so the recess 111aa and support bar ridge 311 do not come into contact with each other. When the movable element 11a runs uncontrollably due to some abnormalities, the recess 111aa can come into contact with the support bar ridge 311 to regulate the movement of the movable element 11a.

As the ridges of the support bars 31 and 41 are regulated such that the support bars 31 and 41 are not rotated by the guides 5, the rotation and X-direction translation of the movable elements 11a and 11b are regulated, but the movable elements 11a and 11b can translate freely in the Y direction. In view of this, in order that the support bars 31 and 41 serve as the Y-direction stoppers for the movable elements 11a and 11b, preferably, for example, the end (e.g., the end of the ridge 311) of each of the support bars 31 and 41 may be formed like an end 311a of Fig. 7, so the anti-rotation member 111a collides against the end 311a. Obviously, the stoppers are not limited to this structure, but, e.g., shock absorbers may be provided. In case the support bar 31 or 41 should run uncontrollably, e.g., shock absorbers 5a are preferably provided as the X-direction stoppers to the two ends in the X-direction stroke of each of the support bars 31 and 41, as shown in Fig. 1A.

In an actual uncontrollable run, the movable elements 11a and 11b rotate and the edges of the recesses of the anti-rotation members 111a, 112a, 111b, and 112b collide against the ridges of the support bars 31 and 41. Then, the recesses of the anti-rotation members 111a and 112a, and 111b and 112b are to slide in the Y direction along the ridges of the support bars 31 and 41. Accordingly, the recesses and ridges may undesirably be broken, dragged, or worn.

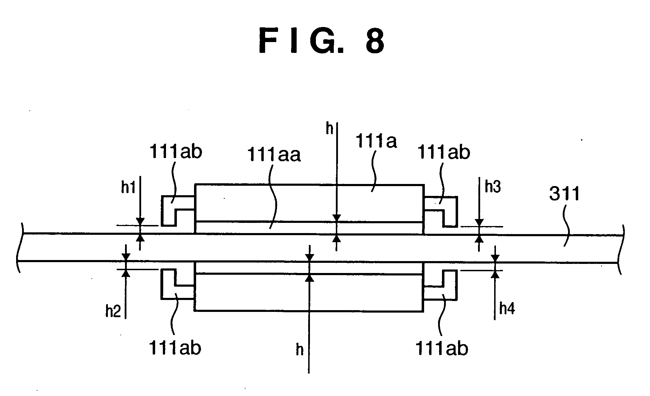

Fig. 8 is a detailed plan view showing a state wherein the recess 111aa of the anti-rotation member 111a and the ridge 311 of the support bar 31 engage with each other in a non-contact state. In the example shown in Fig. 8, stoppers 111ab are provided to the two sides of the anti-rotation member 111a. The stoppers 111ab serve as engaging portions in place of the inner surface of the recess 111aa. For example, the stoppers 111ab preferably have shock absorbing properties and/or are made of a material having a low coefficient of friction (a material having a sufficiently low coefficient of friction so that the stoppers can slide on the ridge). Gaps h1 to h4 between the stoppers 111ab and the ridge 311 of the support bar 31 are each smaller than a gap h between the recess 111aa of the anti-rotation member 111a and the ridge 311 of the support bar 31. Hence, the recess 111aa of the anti-rotation member 111a and the ridge 311 of the support bar 31 do not collide against each other or are not dragged by each other.

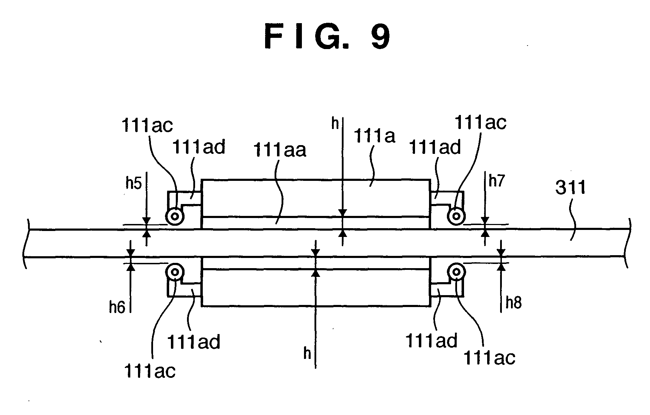

Fig. 9 shows an example in which bearings (rollers) 111ac are provided in place of the stoppers 111ab of Fig. 8. Each bearing 111ac has an outer ring and inner ring, and the inner ring is fixed to the anti-rotation member 111a through a support member 111ad in Fig. 9 so that the outer ring can roll in the transverse direction. The outer ring of the bearing serves as an engaging portion in place of the inner surface of the recess 111aa. Gaps h5 to h8 between the outer rings of the bearings 111ac and the ridge 311 of the support bar 31 are each smaller than the gap h between the recess 111aa of the anti-rotation member 111a and the ridge 311 of the support bar 31. Hence, the anti-rotation member recess 111aa and the support bar ridge 311 do not collide against each other or are not dragged by each other.

C-chamfered portions 11bb are formed as identifying units on the movable element 11b. Sensors (not shown) for discriminating the presence/absence of the C-chamfered portions 11bb are arranged on the support bars 31 and 41 and can identify which movable element engages with which support bar. This is due to the following reason. For example, if the deformation of the bar mirrors mounted on the movable elements differs between the two movable elements, correction of position control by the interferometers during exposure differs between the two movable elements. Assume that the movable elements (stages) run uncontrollably and that the interferometers are reset. If which movable element engages with which support bar is not known, appropriate correction cannot be performed. The identifying units of the movable elements are not limited to the C-chamfered portions 11bb. For example, identification marks having different patterns may be respectively formed on the two movable elements, and the patterns may be read by optical sensors.

The movement of the wafer stage device, particularly, the two movable elements (stages) and support bars, will be described with reference to Figs. 1A to 6B. In the state shown in Figs. 1A and 1B, the wafer (substrate) held on the movable element 11a including the stage by a vacuum chuck or the like has been exposed in the exposure process area 30, and the wafer on the movable element 11b including the stage has been alignment-adjusted in the alignment process area 40 in a parallel manner. The recess (engaging portion) of the anti-rotation member 111a engages with the ridge (regulating portion) 311 of the support bar 31 in a noncontact manner, and the recess (engaging portion) of the anti-rotation member 112b engages with the ridge (regulating portion) 411 of the support bar 41 in a noncontact manner. Referring to Fig. 1A, the hatched anti-rotation members are at the lower positions (at heights where engagement in a noncontact manner is possible), as shown in Fig. 1B, and engage with the ridges of the support bars in a noncontact manner. In this state, the two movable elements 11a and 11b start swapping. First, in Fig. 1A, the movable elements 11a and 11b start moving in directions of arrows.

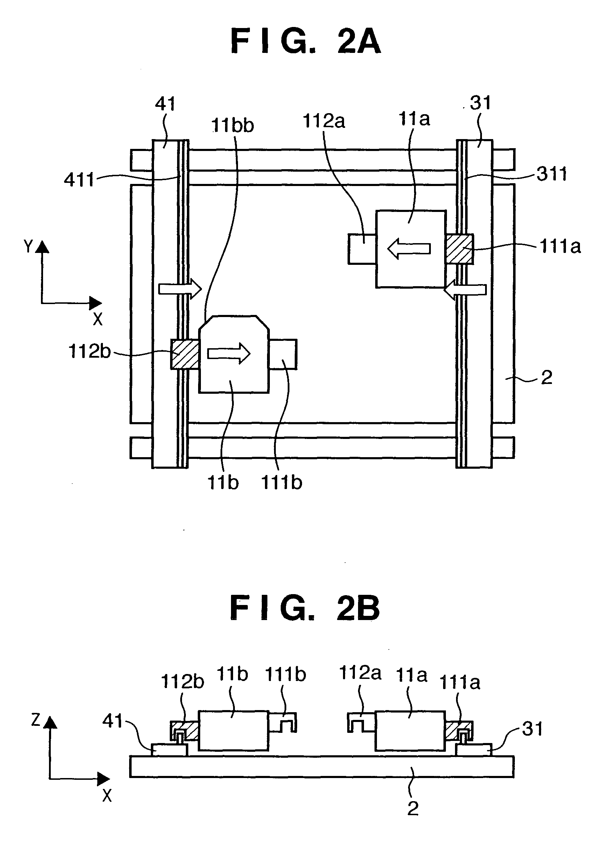

Subsequently, as shown in Fig. 2A, the movable element 11a ends moving in the +Y direction and starts moving in the -X direction. Interlocked with this, the support bar 31 also starts moving in the -X direction. Similarly, the movable element 11b ends moving in the -Y direction and starts moving in the +X direction. Interlocked with this, the support bar 41 also starts moving in the +X direction.

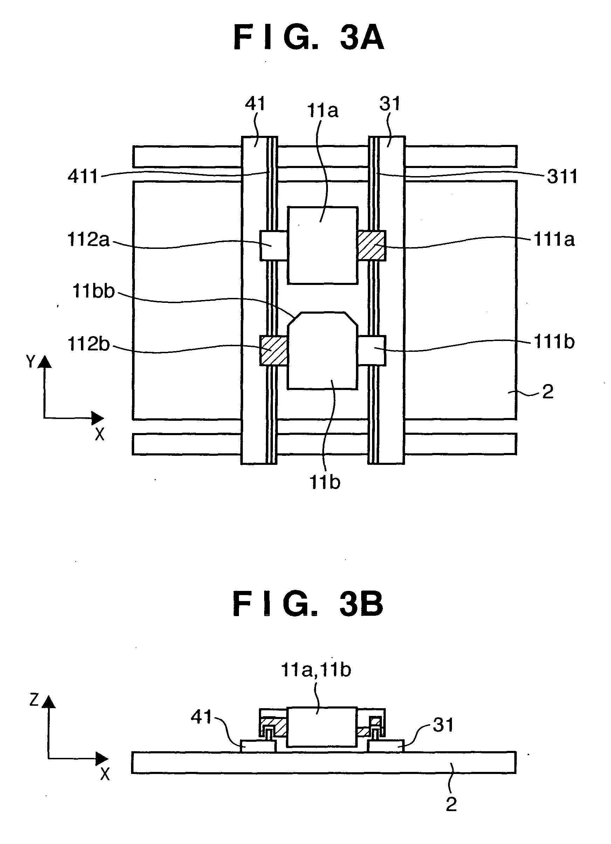

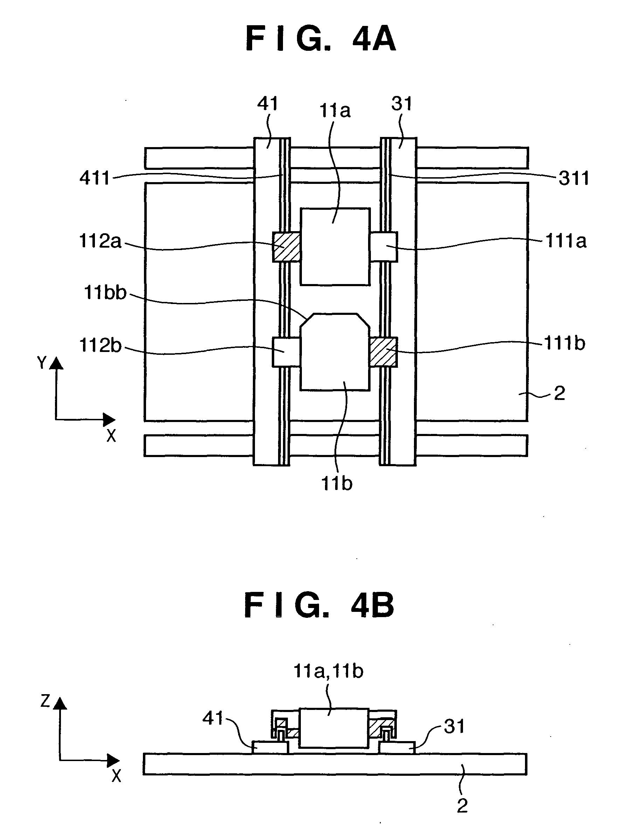

Fig. 3A shows a state wherein the movable elements 11a and 11b have moved to the swap process area 50. The movable elements 11a and 11b and the support bars 31 and 41 stop temporarily. As shown in Figs. 4A and 4B, the anti-rotation members 111a and 112b move upward to the upper positions (at heights where the anti-rotation members are not regulated by the ridges of the support bars), and the anti-rotation members 111b and 112a move downward to the lower positions. In other words, the movable elements 11a and 11b swap. After this, the movable element 11a is to move together with the support bar 41, and the movable element 11b is to move together with the support bar 31.

The area where the position of the movable element can be regulated by the ridge 311 formed on the support bar 31 is the first area, and the area where the position of the movable element can be regulated by the ridge 411 formed on the support bar 41 is the second area. In other words, the position of the movable element located in the first area is regulated by the ridge 311 formed on the support bar 31 so that the movable element will not deviate from the target position. The position of the movable element located in the second area is regulated by the ridge 411 formed on the support bar 41 so that the movable element will not deviate from the target position.

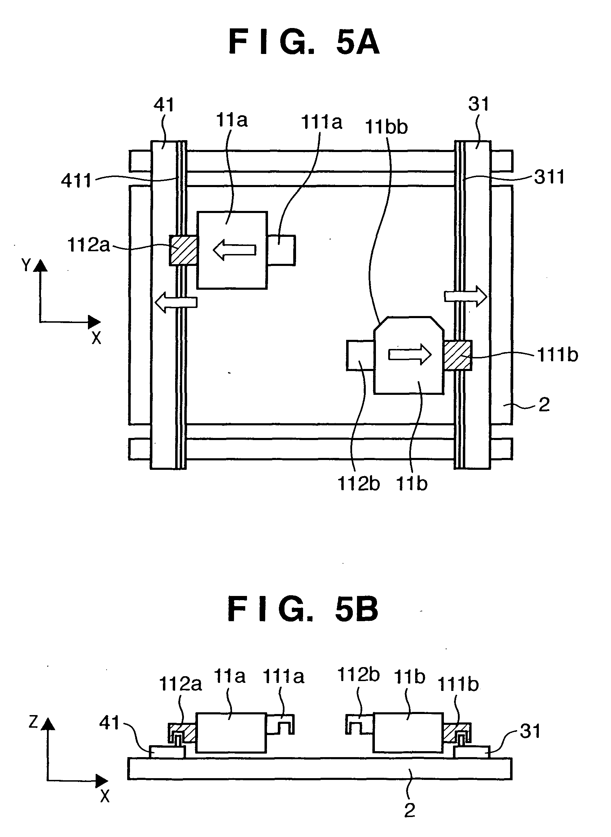

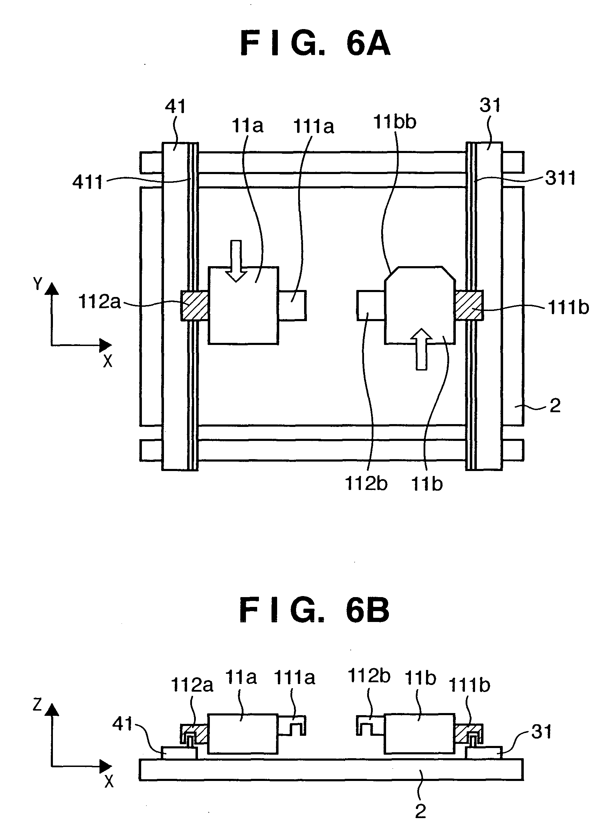

Fig. 5A shows a state wherein the movable element 11a has moved to the alignment process area 40 and the movable element 11b has moved to the exposure process area 30. The support bars 31 and 41 have also moved accordingly. When the movable elements 11a and 11b move in directions of arrows as shown in Fig. 6A, they are restored to the state of Fig. 1A (note that the two movable elements have swapped). The exposed wafer is exchanged at, e.g., the position of the movable element 11a in Fig. 5A, for a new wafer by a robot hand.

In this manner, one cycle is ended. During this one cycle, when the movable elements move, the recesses (engaging portions) of the anti-rotation members and the ridges (regulating portions) of the support bars always engage with each other somewhere in a noncontact manner. This embodiment is of a type in which the recesses of the anti-rotation members move vertically. In an uncontrollable run, when the power supply of the apparatus is turned off for emergency stop, the recesses of the anti-rotation members move downward to the lower positions to engage with the ridges of the support bars. The postures of the movable elements will not be largely changed at any time because the movable elements run uncontrollably to lead to an uncontrollable error. When the power supply is to be turned on to restore the apparatus, if sensors that check whether or not the recesses of the anti-rotation members and the ridges of the support bars engage with each other are provided, even when they engage at a plurality of portions (when the power supply is turned off in the states of Figs. 3A to 4B), which engagement is to be canceled for restoration can be specified.

### (Second Embodiment)

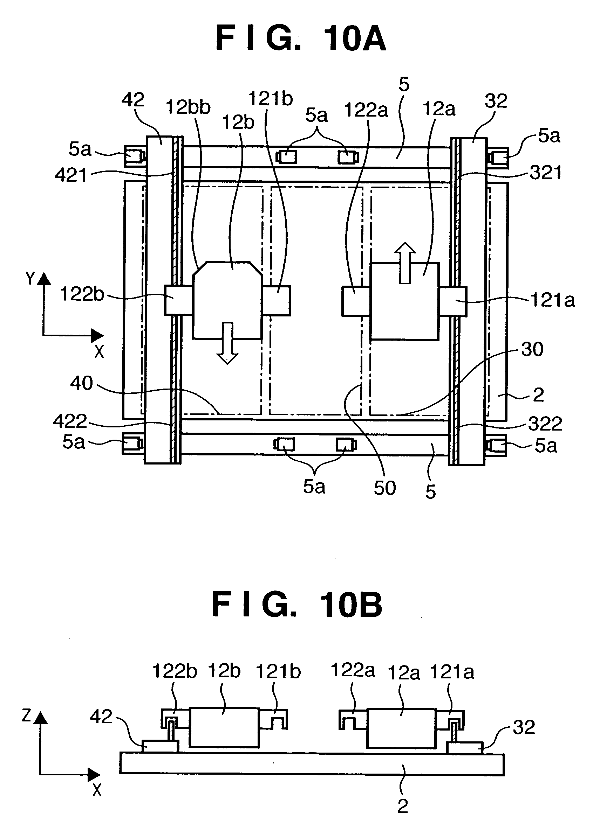

Figs. 10A to 15B are schematic views of a wafer stage device according to the second embodiment of the present invention. Of Figs. 10A to 15B, Figs. 10A, 11A, 12A, 13A, 14A, and 15A are plan views, and Figs. 10B, 11B, 12B, 13B, 14B, and 15B are side views. Figs. 10A to 15B show the movement of the stages at different steps sequentially. In Figs. 10A to 15B, portions that are denoted by the same reference numerals as those shown in Figs. 1A to 6B are the same constituent elements as those of the first embodiment, and a description thereof will be omitted unless otherwise specified.

The wafer stage device has movable elements 12a and 12b each formed to include a stage. C-chamfered portions 12bb serving as identifying units are formed on the movable element 12b to identify the combinations of two movable elements and two support bars. Anti-rotation members 121a and 122a are provided to the side surfaces of the movable element 12a, and anti-rotation members 121b and 122b are provided to the side surfaces of the movable element 12b. The anti-rotation members 121a, 122a, 121b, and 122b have recesses (engaging portions). Support bars 32 and 42 are arranged such that they can be moved in the X direction by a driving mechanism (not shown) along guides 5. In this driving mechanism, for example, magnets can be provided to the support bars 32 and 42, and can drive them by the interaction with a stator 2. Ridges (regulating portions) 321 and 322, and 421 and 422 are provided to the support bars 32 and 42, respectively, such that they are separated at the central portions in the longitudinal directions, and can be vertically moved independently of each other with respect to the corresponding support bars. This is an example of a structure in which the ridge (regulating portion) is divided into a plurality of pieces that can be driven independently of each other.

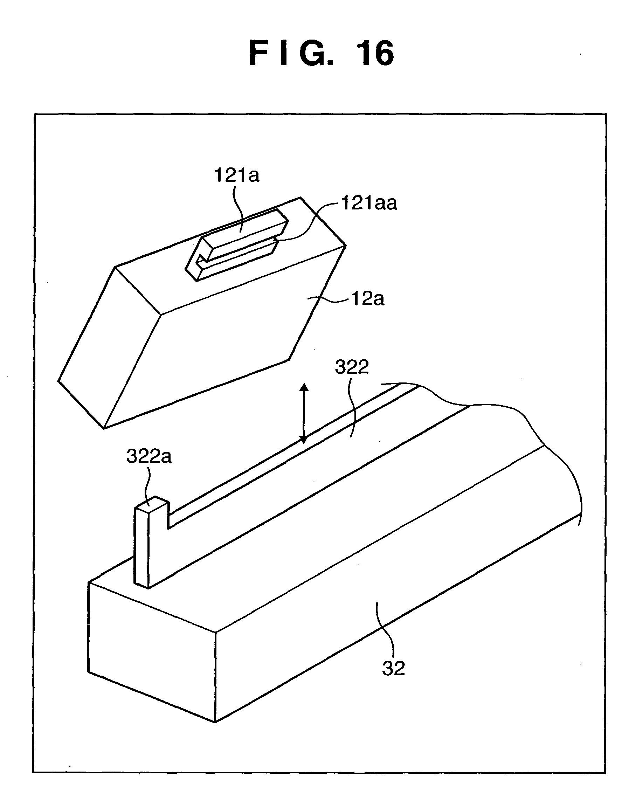

For example, as shown in the exploded perspective view of Fig. 16, the ridge 322 of the support bar 32 moves vertically. Thus, when necessary, a recess 121aa of the anti-rotation member 121a engages with the ridge 322 of the support bar 32 in a noncontact manner. Normally, when the movable element 12a moves in the X direction, the support bar 32 also moves in the X direction by a corresponding amount, so that the recess 121aa and support bar ridge 322 do not come into contact with each other. When the movable element 12a runs uncontrollably due to some abnormalities, the recess 121aa can come into contact with the support bar ridge 322 to regulate the movement of the movable element 12a.

As the ridges of the support bars 32 and 42 are regulated such that the support bars 32 and 42 are not rotated by the guides 5, the rotation and X-direction translation of the movable elements 12a and 12b are regulated, but the movable elements 12a and 12b can translate freely in the Y direction. In view of this, in order that the support bars 32 and 42 serve as the Y-direction stoppers for the movable elements 12a and 12b, preferably, for example, the end (e.g., the end of the ridge) of each of the support bars 32 and 42 may be formed like an end 322a of Fig. 16, so the anti-rotation member 121a collides against the end 322a. Obviously, the stoppers are not limited to this structure, but, e.g., shock absorbers may be provided. In case the support bar 32 or 42 should run uncontrollably, e.g., shock absorbers 5a are preferably provided as the X-direction stoppers to the two ends in the X-direction stroke of each support bar, as shown in Fig. 10A.

As described in the first embodiment with reference to Figs. 8 and 9, the anti-rotation member is preferably provided with stoppers or bearings (rollers) at its two sides, so that the recess of the anti-rotation member and the support bar ridge will not collide against or be dragged by each other.

The movement of the wafer stage device, particularly the movable elements (stages) and support bars, will be described with reference to Figs. 10A to 15B. In the state shown in Figs. 10A and 10B, the wafer (substrate) held on the movable element 12a including the stage by a vacuum chuck or the like has been exposed in an exposure process area 30, and the wafer on the movable element 12b including the stage has been alignment-adjusted in an alignment process area 40 in a parallel manner. The anti-rotation member 121a engages with the ridges 321 and 322 of the support bar 32 in a noncontact manner, and the anti-rotation member 122b engages with the ridges 421 and 422 of the support bar 42 in a noncontact manner. Referring to Fig. 10A, the hatched ridges of the support bars are at upper positions and engage with the recesses of the anti-rotation members. In this state, the two movable elements 12a and 12b start swapping. First, in Fig. 10A, the movable elements 12a and 12b start moving in directions of arrows.

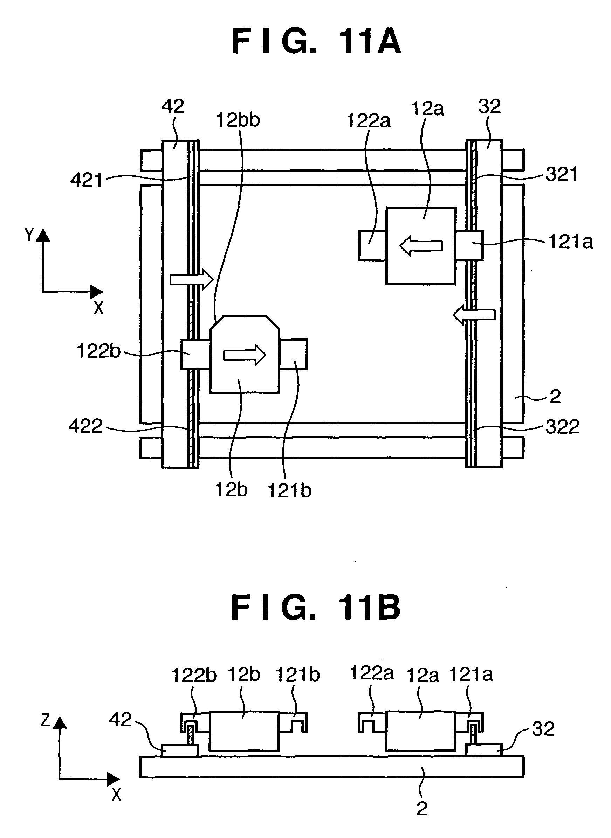

Subsequently, as shown in Fig. 11A, the movable element 12a moves in the +Y direction with the anti-rotation member 121a engaging with the ridge 321 of the support bar 32 in a noncontact manner. During this movement, the support bar ridge 322 moves downward to the lower position. When the movable element 12a ends moving in the +Y direction, it starts moving in the -X direction. Interlocked with this, the support bar 32 also starts moving in the -X direction (arrows in Fig. 11A). Similarly, the movable element 12b moves in the -Y direction with the anti-rotation member 122b engaging with the ridge 422 of the support bar 42 in a noncontact manner. During this movement, the ridge 421 of the support bar 42 moves downward to the lower position. When the movable element 12b ends moving in the -Y direction, it starts moving in the +Y direction. Interlocked with this, the support bar 42 also starts moving in the +X direction (arrows in Fig. 11A).

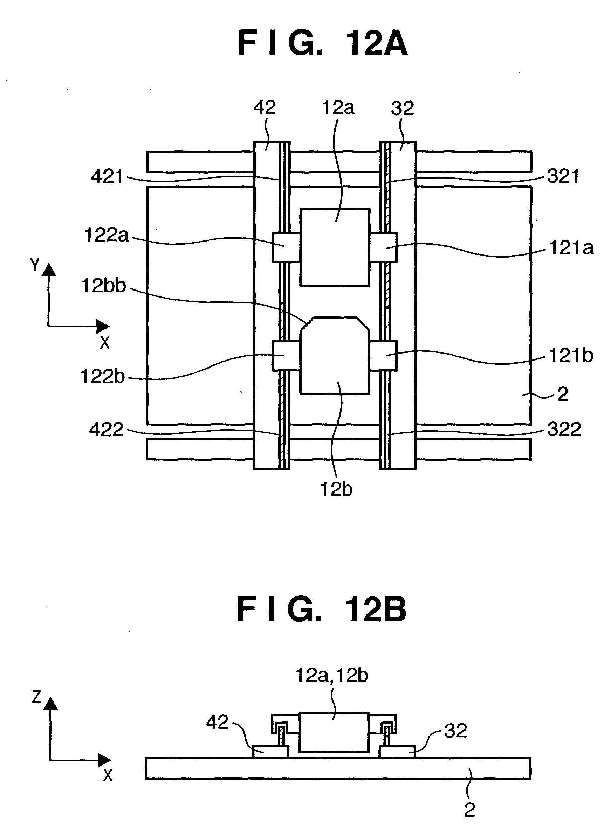

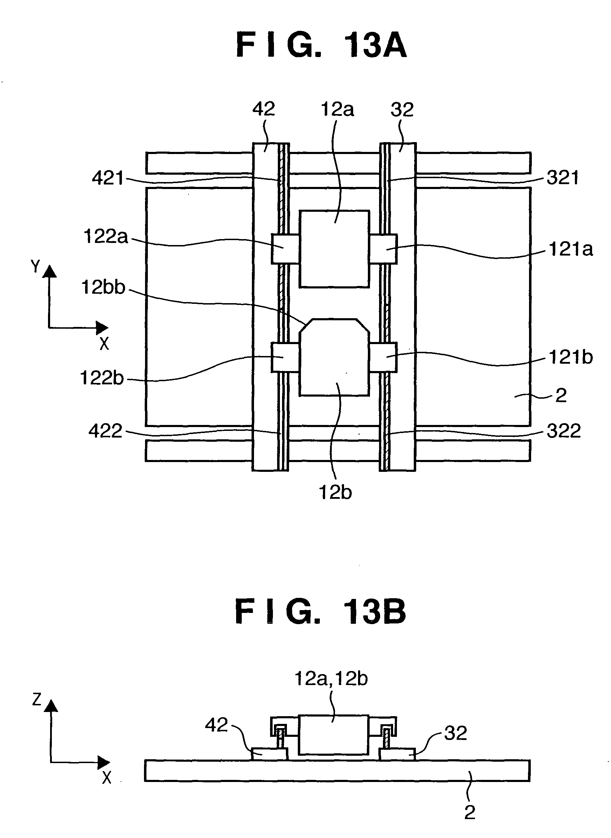

Fig. 12A shows a state wherein the movable elements 12a and 12b have moved to a swap process area 50. The movable elements 12a and 12b and the support bars 32 and 42 stop temporarily. As shown in Fig. 13A, the ridges 322 and 421 of the support bars 32 and 42 move upward to the upper positions, and the ridges 321 and 422 of the support bars 32 and 42 move downward to the lower positions. In other words, the movable elements 12a and 12b swap. After this, the movable element 12a is to move together with the support bar 42, and the movable element 12b is to move together with the support bar 32.

The area where the position of the movable element can be regulated by the ridges 321 and 322 formed on the support bar 32 is the first area, and the area where the position of the movable element can be regulated by the ridges 421 and 422 formed on the support bar 42 is the second area. In other words, the position of the movable element located in the first area is regulated by the ridges 321 and 322 formed on the support bar 32 so that the movable element will not deviate from the target position. The position of the movable element located in the second area is regulated by the ridges 421 and 422 formed on the support bar 42 so that the movable element will not deviate from the target position.

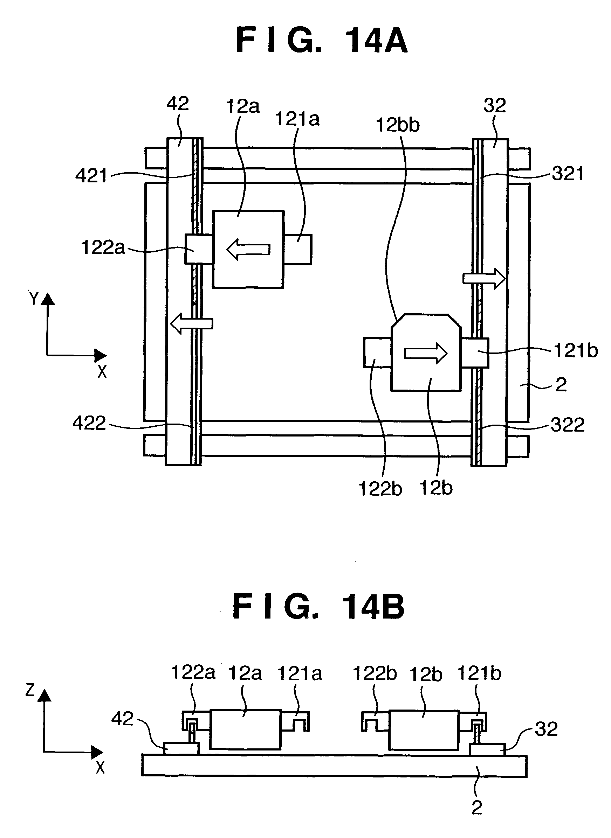

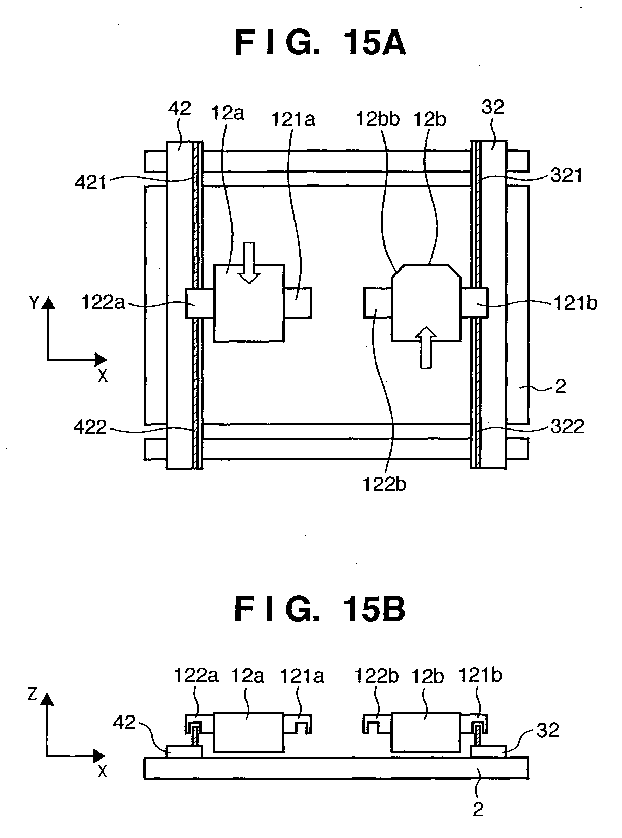

Fig. 14A shows a state wherein the movable element 12a has moved to the alignment process area 40 and the movable element 12b has moved to the exposure process area 30. The support bars 32 and 42 have also moved accordingly. When the movable elements 12a and 12b move in directions of arrows as shown in Fig. 15A, they are restored to the state of Fig. 10A (note that the two movable elements have swapped).

In this manner, one cycle is ended. During this one cycle, when the movable elements move, the recesses (engaging portions) of the anti-rotation members and the support bar ridges (regulating portions) always engage with each other somewhere in a noncontact manner. This embodiment is of a type in which the ridges of the support bars move vertically. In an uncontrollable run, when the power supply of the apparatus is turned off for emergency stop, the ridges of the support bars move upward to the upper positions to engage with the recesses of the anti-rotation members. The postures of the movable elements will not be largely changed at any time because the movable elements do not run uncontrollably to lead to an uncontrollable error. When the power supply is to be turned on to restore the apparatus, if sensors that check whether or not the recesses of the anti-rotation members and the ridges of the support bars engage with each other are provided, even when they engage at a plurality of portions (when the power supply is turned off in the states of Figs. 12A to 13B), which engagement is to be canceled for restoration can be specified.

Furthermore, according to this embodiment, the anti-rotation members need not be driven, so that power feeding to the movable elements can be suppressed.

### (Third Embodiment)

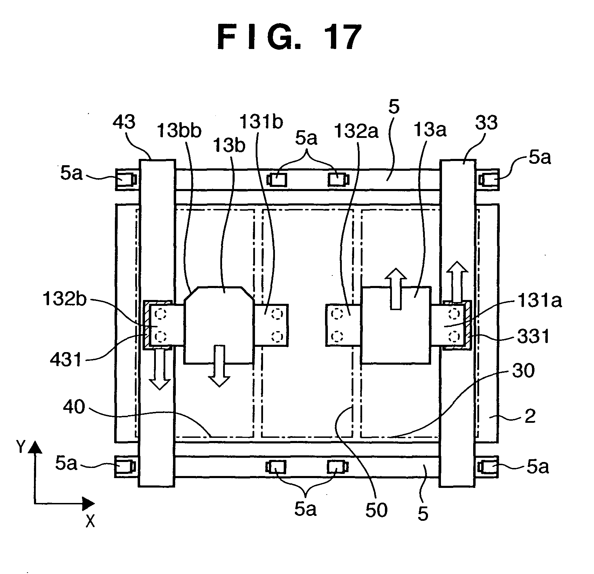

Figs. 17 to 24 are schematic plan views of a wafer stage device according to the third embodiment of the present invention, and show the movement of the stages at different steps sequentially.

The wafer stage device has movable elements 13a and 13b each formed to include a stage. C-chamfered portions 13bb serving as identifying units are formed on the movable element 13b to identify the combinations of two movable elements and two support bars. Anti-rotation members 131a and 132a are provided to the side surfaces of the movable element 13a, and anti-rotation members 131b and 132b are provided to the side surfaces of the movable element 13b. The anti-rotation members 131a, 132a, 131b, and 132b have holes (engaging portions). Support bars 33 and 43 are arranged such that they can be moved in the X direction by a driving mechanism (not shown) along guides 5. In this driving mechanism, for example, magnets can be provided to the support bars 33 and 43, and can drive them by the interaction with a stator 2. Slide members 331 and 431 are provided to the support bars 33 and 43, respectively, and can be moved in the Y direction by the driving mechanism (not shown) with respect to the support bars 33 and 43, respectively.

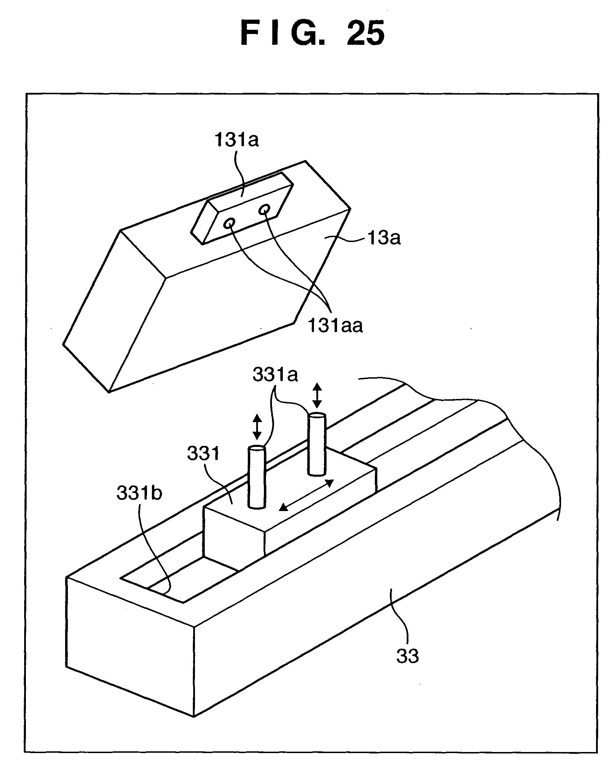

For example, as shown in the exploded perspective view of Fig. 25, two projections (regulating portions) 331a formed on the slide member 331 move vertically. Thus, when necessary, two holes (engaging portions) 131aa of the anti-rotation member 131a and the projections (regulating portions) 331a engage with each other in a noncontact manner. The support bars and slide members are position-measured by interferometers and driven on the basis of the measurement results. Normally, when the movable element 13a moves in the X direction, the support bar 33 also moves in the X direction by a corresponding amount. When the movable element 13a moves in the Y direction, the slide member 331 also moves in the Y direction by a corresponding amount. Thus, the holes 131aa and projections 331a do not come into contact with each other. When the movable element 13a runs uncontrollably due to some abnormalities, the inner surfaces of the holes 131aa can come into contact with the projections 331a to regulate the movement of the movable element.

As the projections 331a and 431a of the slide members 331 and 431 are regulated such that the support bars 33 and 43 are not rotated by the guides 5, the rotation, X-direction translation, and Y-direction translation of the movable elements can be regulated. As the slide members 331 and 431 can move freely in the Y direction with respect to the support bars 33 and 43, an end 331b of the support bar 33 serves as a stopper. Obviously, the stoppers are not limited to this structure, but, e.g., shock absorbers may be provided. In case the support bar 33 or 43 should run uncontrollably, e.g., shock absorbers 5a are preferably provided as the X-direction stoppers to the two ends in the X-direction stroke of each support bar, as shown in Fig. 17.

The movement of the wafer stage device, particularly the movable elements (stages) and support bars, will be described with reference to Figs. 17 to 24. In the state shown in Fig. 17, the wafer (substrate) held on the movable element 13a including the stage by a vacuum chuck or the like has been exposed in an exposure process area 30, and the wafer on the movable element 13b including the stage has been alignment-adjusted in an alignment process area 40 in a parallel manner. The holes (engaging portions) of the anti-rotation member 131a engage with the projections (regulating portions) of the slide member 331 in a noncontact manner, and the holes (engaging portions) of the anti-rotation member 132b engage with the projections (regulating portions) of the slide member 431 in a noncontact manner. Referring to Fig. 17, the projections (regulating portions) of the hatched slide members have moved to upper positions and engage with the holes of the anti-rotation members in a noncontact manner. In this state, the two movable elements 13a and 13b start swapping. First, in Fig. 17, the movable elements 13a and 13b start moving in directions of arrows. Interlocked with this, the slide members 331 and 431 also start moving.

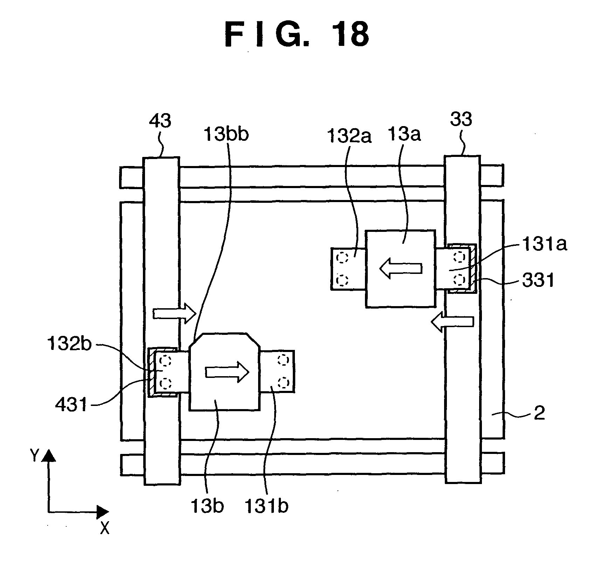

Subsequently, as shown in Fig. 18, the movable element 13a moves in the +Y direction with the holes of the anti-rotation member 131a engaging with the projections of the slide member 331 in a noncontact manner. Interlocked with this, the slide member 331 also moves in the +Y direction. When the movable element 13a ends moving in the +Y direction, it starts moving in the -X direction. Interlocked with this, the support bar 33 also starts moving in the -X direction (indicated by arrows in Fig. 18). Note that the slide member 331 stops. Similarly, the movable element 13b moves in the -Y direction with the holes of the anti-rotation member 132b engaging with the projections of the slide member 431 in a noncontact manner. Interlocked with this, the slide member 431 also moves in the -Y direction. When the movable element 13b ends moving in the -Y direction, it starts moving in the +X direction. Interlocked with this, the support bar 43 also starts moving in the +X direction (indicated by arrows in Fig. 18). Note that the slide member 431 stops.

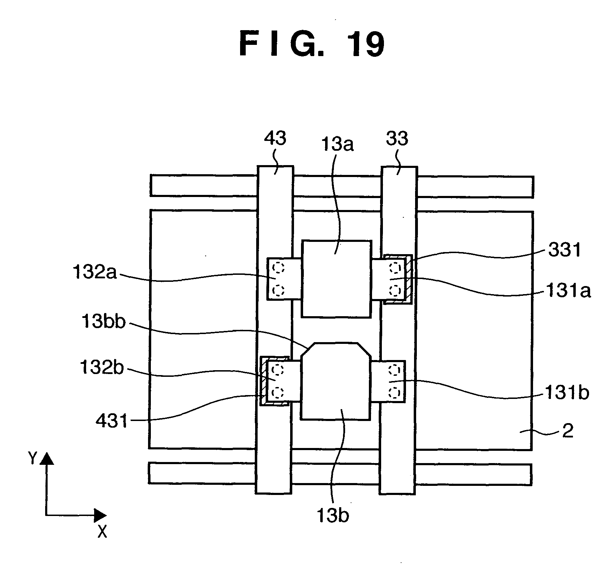

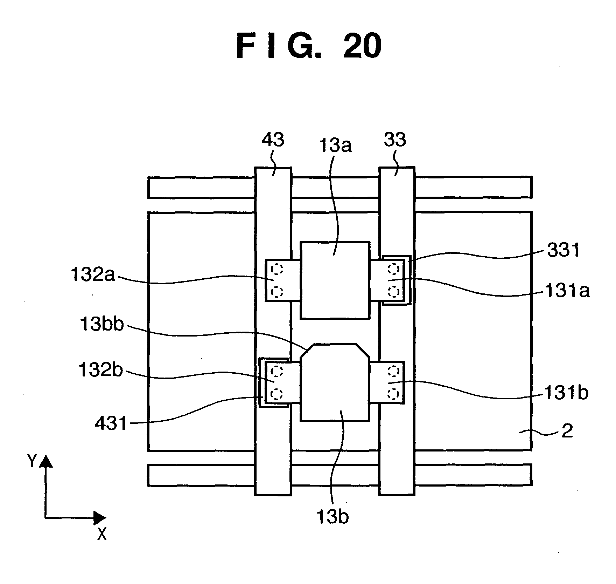

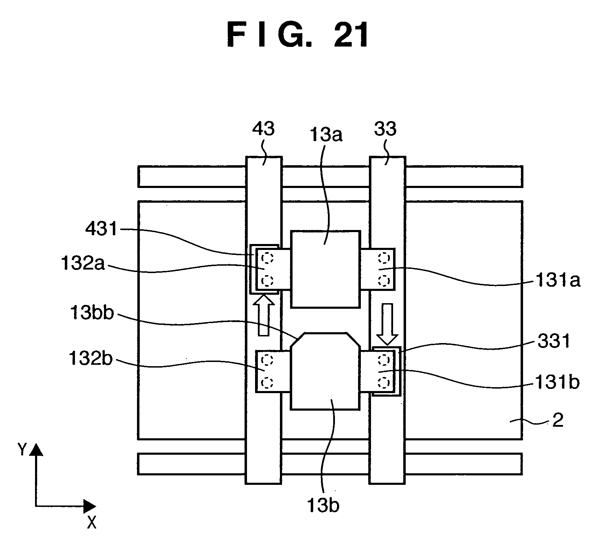

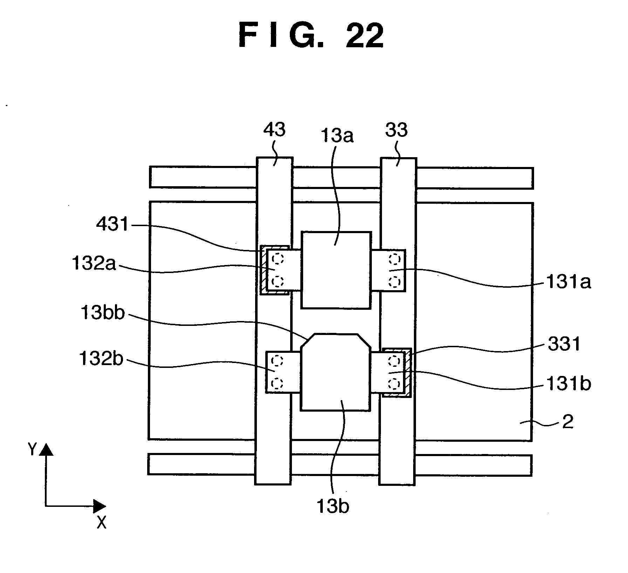

Fig. 19 shows a state wherein the movable elements 13a and 13b have moved to a swap process area 50. The movable elements 13a and 13b and the support bars 33 and 43 stop temporarily. As shown in Fig. 20, the projections of the slide members 331 and 431 move downward to the lower positions, and their engagement with the anti-rotation members 131a and 132b in a noncontact manner is canceled. As indicated by arrows in Fig. 21, the slide members 331 and 431 move in the -Y and +Y directions, respectively. As shown in Fig. 22, the projections of the slide members 331 and 431 move upward to the upper positions, and the holes of the anti-rotation member 132a engage with the projections of the slide member 431 in a noncontact manner and the holes of the anti-rotation member 131b engage with the projections of the slide member 331 in a noncontact manner. In other words, the movable elements 13a and 13b swap. After this, the movable element 13a is to move together with the support bar 43, and the movable element 13b is to move together with the support bar 33.

The area where the position of the movable element can be regulated by the projections (regulating portions) formed on the slide member 331 which moves along the support bar 33 is the first area, and the area where the position of the movable element can be regulated by the projections (regulating portions) formed on the slide member 431 which moves along the support bar 43 is the second area. In other words, the position of the movable element located in the first area is regulated by the projections (regulating portions) formed on the slide member 331 which moves along the support bar 33 so that the movable element will not deviate from the target position. The position of the movable element located in the second area is regulated by the projections (regulating portions) formed on the slide member 431 which moves along the support bar 43 so that the movable element will not deviate from the target position.

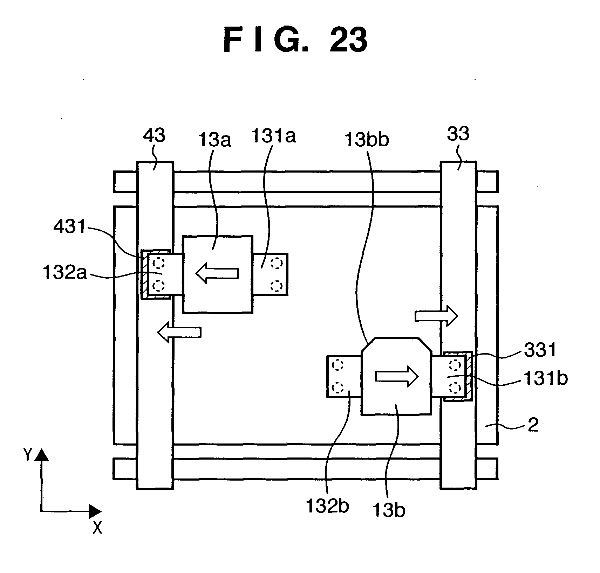

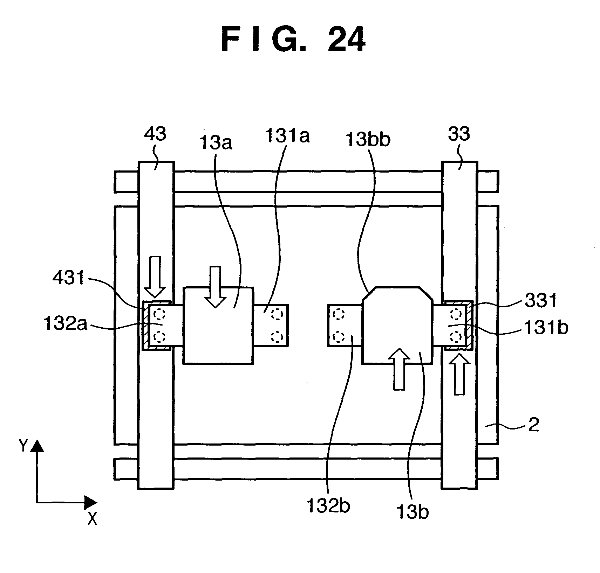

Fig. 23 shows a state wherein the movable element 13a has moved to the alignment process area 40 and the movable element 13b has moved to the exposure process area 30. The support bars 33 and 43 have also moved accordingly. When the movable elements 13a and 13b and the slide members 331 and 431 move in directions of arrows as shown in Fig. 24, they are restored to the state of Fig. 17 (note that the two movable elements have swapped).

In this manner, one cycle is ended. During this one cycle, when the movable elements move, the holes (engaging portions) of the anti-rotation members and the projections (regulating portions) of the slide members always engage with each other somewhere in a noncontact manner. The postures of the movable elements will not be largely changed at any time because the movable elements do not run uncontrollably to lead to an uncontrollable error. In this embodiment, the slide members run by themselves on the support bars in the Y direction. If the cables for supplying power to the movable elements are attached to the movable elements through the slide members, the movable elements will not receive load change from the cables.

### (Fourth Embodiment)

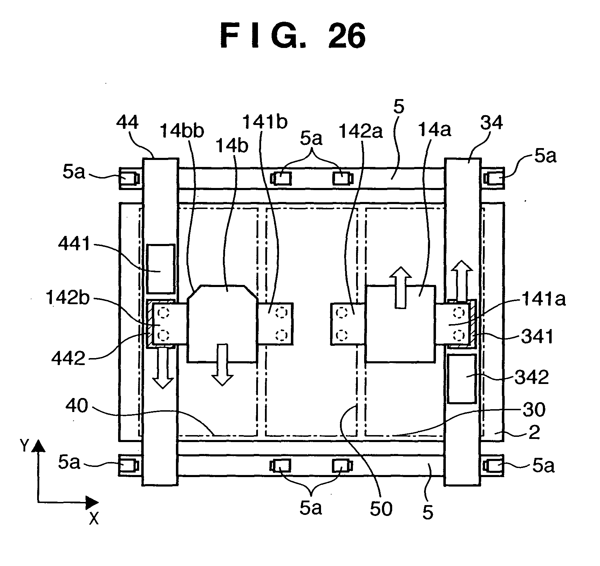

Figs. 26 to 32 are schematic plan views of a wafer stage device according to the fourth embodiment of the present invention, and show the movement of the stages at different steps sequentially.

The wafer stage device has movable elements 14a and 14b each formed to include a stage. C-chamfered portions 14bb serving as identifying units are formed on the movable element 14b to identify the combinations of two movable elements and two support bars. Anti-rotation members 141a and 142a are provided to the side surfaces of the movable element 14a, and anti-rotation members 141b and 142b are provided to the side surfaces of the movable element 14b. The anti-rotation members 141a, 142a, 141b, 142b have holes (engaging portions). Support bars 34 and 44 are arranged such that they can be moved in the X direction by a driving mechanism (not shown) along guides 5. In this driving mechanism, for example, slide members 341 and 342, and 441 and 442 are provided to the support bars 34 and 44, respectively, and can be moved by a driving mechanism (not shown) in the Y direction with respect to the support bars 33 and 44.

The structure of the movable elements and support bars is identical to that of the third embodiment (Fig. 25). Normally, the holes (engaging portions) of the anti-rotation members and the projections (regulating portions) of the slide members engage with each other in a noncontact manner. When the movable element runs uncontrollably due to some abnormalities, the holes of the anti-rotation member can come into contact with the projections (regulating portions) of the slide member to regulate the movement of the movable element.

As the projections of the slide members 341 and 342, and 441 and 442 are regulated such that the support bars 34 and 44 are not rotated by the guides 5, the rotation, X-direction translation, and Y-direction translation of the movable elements can be regulated, but the slide members 341 and 342, and 441 and 442 can move freely in the Y direction with respect to the support bars 34 and 44. Thus, the ends of the support bars 34 and 44 serve as stoppers in the same manner as the support bar 33, as shown in Fig. 25. Obviously, the stoppers are not limited to this structure, but, e.g., shock absorbers may be provided. In case the support bar 34 or 44 should run uncontrollably, e.g., shock absorbers 5a are preferably provided as the X-direction stoppers to the two ends in the X-direction stroke of each of the support bars 34 and 44, as shown in Fig. 26.

The movement of the wafer stage device, particularly the movable elements (stages) and support bars, will be described with reference to Figs. 26 to 32. In the state shown in Fig. 26, the wafer held on the movable element 14a including the stage by a vacuum chuck or the like has been exposed in an exposure process area 30, and the wafer on the movable element 14b including the stage has been alignment-adjusted in an alignment process area 40 in a parallel manner. The holes (engaging portions) of the anti-rotation member 141a engage with the projections (regulating portions) of the slide member 341 in a noncontact manner, and the holes (engaging portions) of the anti-rotation member 142b engage with the projections (regulating portions) of the slide member 442 in a noncontact manner. Referring to Fig. 26, the projections (regulating portions) of the hatched side members are at the upper positions and engage with the holes (engaging portions) of the anti-rotation members. In this state, the two movable elements start swapping. First, in Fig. 26, the movable elements 14a and 14b start moving in directions of arrows. Interlocked with this, the slide members 341 and 442 also start moving.

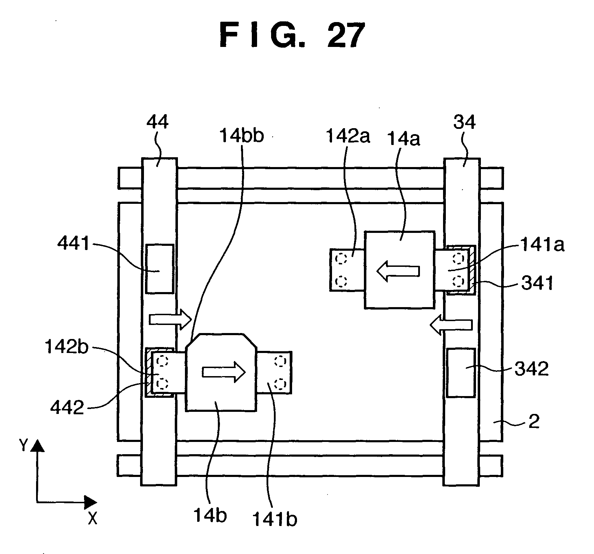

Subsequently, as shown in Fig. 27, the movable element 14a moves in the +Y direction with the holes of the anti-rotation member 141a engaging with the slide member 341 in a noncontact manner. Interlocked with this, the slide member 341 also moves in the +Y direction. When the movable element 14a ends moving in the +Y direction, it starts moving in the -X direction. Interlocked with this, the support bar 34 also starts moving in the -X direction (arrows in Fig. 27). Note that the slide member 341 stops. Similarly, the movable element 14b moves in the -Y direction with the holes of the anti-rotation member 142b engaging with the slide member 442 in a noncontact manner. Interlocked with this, the slide member 442 moves in the -Y direction. When the movable element 14b ends moving in the -Y direction, it starts moving in the +X direction. Interlocked with this, the support bar 44 also starts moving in the +X direction (arrows in Fig. 27). Note that the slide member 442 stops.

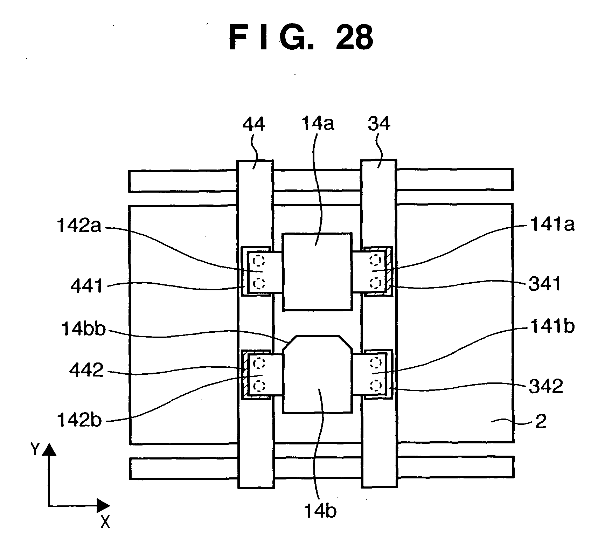

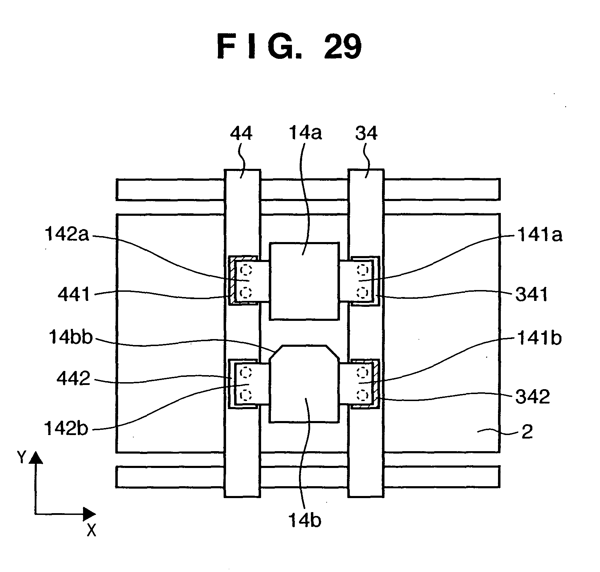

Fig. 28 shows a state wherein the movable elements 14a and 14b have moved to a swap process area 50. The slide member 342 has preferably been moved in advance to a position where it can engage with the anti-rotation member 141b in a noncontact manner. Similarly, the slide member 441 has preferably been moved in advance to a position where it can engage with the anti-rotation member 142a in a noncontact manner. The movable elements 14a and 14b and the support bars 34 and 44 stop temporarily. As shown in Fig. 29, the projections of the slide members 341 and 442 move downward to the lower positions, and the projections of the slide members 342 and 441 move upward to the upper positions. In other words, the movable elements 14a and 14b swap. After this, the movable element 14a is to move together with the support bar 44, and the movable element 14b is to move together with the support bar 34.

The area where the position of the movable element can be regulated by the projections (regulating portions) formed on the slide members 341 and 342 which move along the support bar 34 is the first area, and the area where the position of the movable element can be regulated by the projections (regulating portions) formed on the slide members 441 and 442 which move along the support bar 44 is the second area. In other words, the position of the movable element located in the first area is regulated by the projections (regulating portions) formed on the slide members 341 and 342 which move along the support bar 34 so that the movable element will not deviate from the target position. The position of the movable element located in the second area is regulated by the projections (regulating portions) formed on the slide members 441 and 442 which move along the support bar 44 so that the movable element will not deviate from the target position.

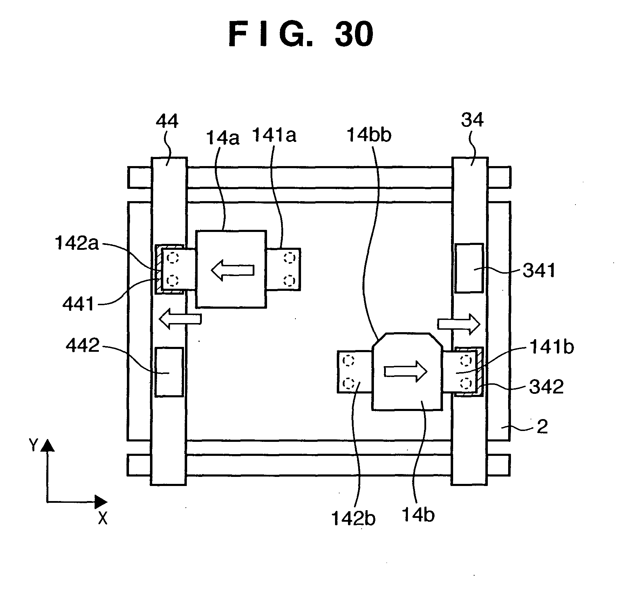

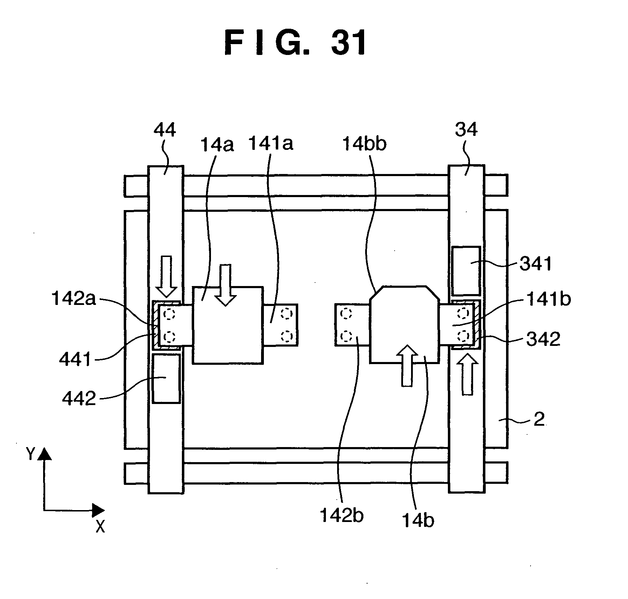

Fig. 30 shows a state wherein the movable element 14a has moved to the alignment process area 40 and the movable element 14b has moved to the exposure process area 30. The support bars 34 and 44 have also moved accordingly. When the movable elements 14a and 14b and side members 342 and 441 move in directions of arrows as shown in Fig. 31, they are restored to the state of Fig. 26 (note that the movable elements have swapped).

In this embodiment, since one support bar is provided with two slide members, when the two, right and left movable elements are to swap as in the third embodiment (see Fig. 21), the slide members need not move. Therefore, the throughput is increased.

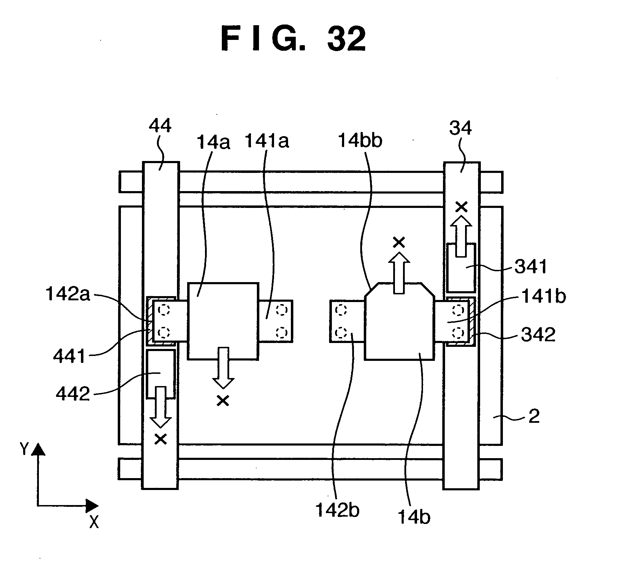

In this manner, one cycle is ended. During this one cycle, when the movable elements move, the holes (engaging portions) of the anti-rotation members and the projections (regulating portions) of the slide members always engage with each other somewhere in a noncontact manner. This embodiment is of a type in which the projections of the slide members move vertically. In an uncontrollable run, when the power supply of the apparatus is turned off for emergency stop, the projections of the slide members move upward to the upper positions to engage with the holes of the anti-rotation members. The postures of the movable elements will not be largely changed at any time because the movable elements do not run uncontrollably to lead to an uncontrollable error. When the power supply is to be turned on to restore the apparatus, if sensors that check whether or not the holes of the anti-rotation members and the projections of the slide members engage with each other are provided, even when they engage at a plurality of portions (when the power supply is turned off in the states of Figs. 28 and 29), which engagement is to be canceled for restoration can be specified. Note that if the movement in the second cycle is to be set in directions equal to those (arrows in Fig. 32) in the first cycle, as shown in Fig. 32, the slide members 341 and 442 are pushed out by the slide members 342 and 441 to the ends of the support bars to cause an inconvenience. To prevent this, the moving directions of the movable elements 14a and 14b are preferably reversed in each cycle.

### (Fifth Embodiment)

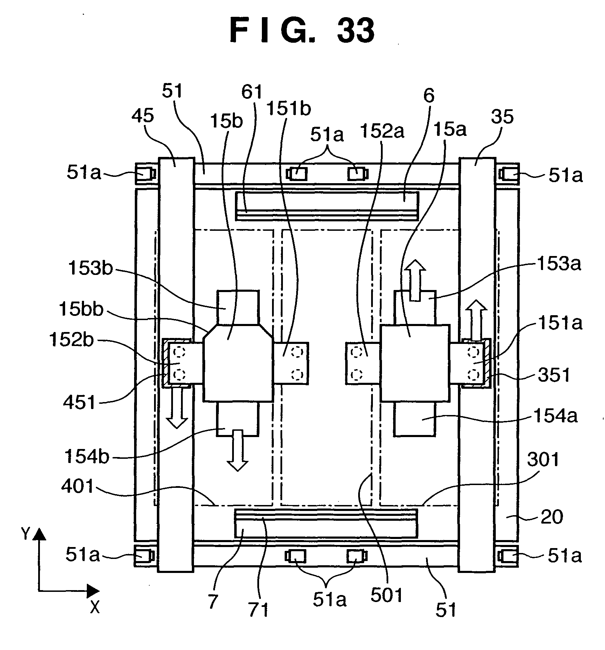

Figs. 33 to 42 are schematic plan views of a wafer stage device according to the fifth embodiment of the present invention, and show the movement of the stages at different steps sequentially. The wafer stage device has a stator 20 and two movable elements 15a and 15b. The stator 20 and movable element 15a form one plane motor, and the stator 20 and movable element 15b form the other plane motor. C-chamfered portions 15bb serving as identifying units are formed on the movable element 15b to identify the combinations of two movable elements and two support bars.

Anti-rotation members 151a, 152a, 153a, and 154a are provided to the side surfaces of the movable element 15a, and anti-rotation members 151b, 152b, 153b, and 154b are provided to the side surfaces of the movable element 15b. Of the anti-rotation members, each of the anti-rotation members 151a, 152a, 151b, and 152b has two holes (engaging portions) in the same manner as the anti-rotation member 131a of Fig. 25, and the anti-rotation members 153a, 154a, 153b, and 154b have recesses (engaging portions) in the same manner as the anti-rotation member 121a of Fig. 16.

Support bars 35 and 45 are arranged such that they can be moved in the X direction by a driving mechanism (not shown) along guides 51. In this driving mechanism, for example, magnets can be provided to the support bars 35 and 45, and can drive them by the interaction with the stator 20. Slide members 351 and 451 each having two projections (regulating portions), like the projections 331a (regulating portions) of Fig. 25, are provided to the support bars 35 and 45, respectively, and can be moved in the Y direction by the driving mechanism (not shown) with respect to the support bars. Fixed bars 6 and 7 respectively have ridges 61 and 71 which move vertically with respect to the fixed bars 6 and 7.

The projections (regulating portions) formed on the slide members 351 and 451 move vertically. Thus, when necessary, the holes (engaging portions) of the anti-rotation members 151a and 152a, and 151b and 152b and the projections (regulating portions) of the corresponding slide members 351 and 451 engage with each other in a noncontact manner. The ridges (regulating portions) 61 and 71 formed on the fixed bars 6 and 7 move vertically. Thus, when necessary, the recesses (engaging portions) of the anti-rotation members 153a and 154a, and 153b and 154b and the ridges (regulating portions) 61 and 71 of the corresponding fixed bars 6 and 7 engage with each other in a noncontact manner.

When the holes of the anti-rotation members 151a and 152a, and 151b and 152b engage with the corresponding projections of the slide members 351 and 451 of the support bars 35 and 45, the projections of the slide members 351 and 451 are regulated such that the support bars 35 and 45 are not rotated by the guides 51. Thus, the rotation, X-direction translation, and Y-direction translation of the movable elements 15a and 15b can be regulated. As the slide members 351 and 451 can move freely in the Y direction with respect to the support bars 35 and 45, the ends of the support bars 35 and 45 serve as stoppers, in the same manner as in the support bar 33 shown in Fig. 25. Obviously, the stoppers are not limited to this structure, but, e.g., shock absorbers may be provided. In case the support bar 35 or 45 should run uncontrollably, e.g., shock absorbers 51a are provided as the X-direction stoppers to the two ends in the X-direction stroke of each support bar as shown in Fig. 33.

When the recesses of the anti-rotation members 153a and 154a, and 153b and 154b engage with the ridges 61 and 71 of the fixed bars 6 and 7, the ridges 61 and 71 of the fixed bars 6 and 7 can regulate the rotation and Y-direction translation of the movable elements 15a and 15b, but the movable elements 15a and 15b can translate freely in the X direction. Therefore, the ends of the fixed bars are preferably formed each like the end 322a shown in Fig. 16, so that they can serve as stoppers. Obviously, the stoppers are not limited to this structure, but, e.g., shock absorbers may be provided. As has been described in the first embodiment with reference to Figs. 8 and 9, stoppers or bearings are preferably provided to the two sides of each of the anti-rotation members 153a, 154a, 153b, and 154b, so that the recesses of the anti-rotation members and the ridges of the fixed bars will not collide against or be dragged by each other.

The movement of the wafer stage device, particularly the movable elements (stages), support bars, and fixed bars will be described with reference to Figs. 33 to 42. In the state shown in Fig. 33, the wafer (substrate) held on the movable element 15a including the stage by a vacuum chuck or the like has been exposed in an exposure process area 301, and the wafer on the movable element 15b including the stage has been alignment-adjusted in an alignment process area 401 in a parallel manner. The holes (engaging portions) of the anti-rotation member 151a engage with the projections (regulating portions) of the slide member 351 in a noncontact manner, and the holes (engaging portions) of the anti-rotation member 152b engage with the projections (regulating portions) of the slide member 451 in a noncontact manner. Referring to Fig. 33, the projections of the hatched slide members have moved to the upper positions and engage with the holes of the anti-rotation members in a noncontact manner. In this state, the two, left and right movable elements start swapping. First, in Fig. 33, the movable elements 15a and 15b start moving in directions of arrows. Interlocked with this, the slide members 351 and 451 also start moving.

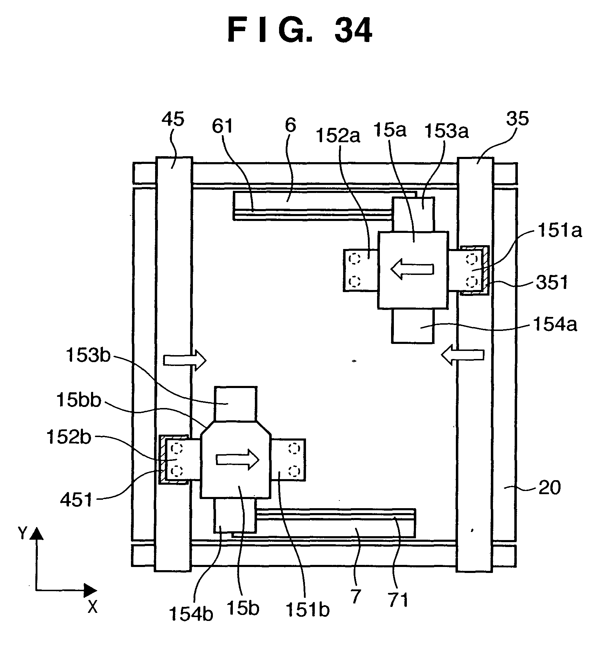

Subsequently, as shown in Fig. 34, the movable element 15a moves in the +Y direction with the holes of the anti-rotation member 151a engaging with the projections of the slide member 351 in a noncontact manner. Interlocked with this, the slide member 351 also moves in the +Y direction. When the movable element 15a ends moving in the +Y direction, it starts moving in the -X direction. Interlocked with this, the support bar 35 also starts moving in the -X direction (indicated by arrows in Fig. 34). Note that the slide member 351 stops. At this time, the ridge 61 of the fixed bar 6 is at the lower position. When the ridge 61 of the fixed bar 6 moves upward to the upper position, it can engage with the anti-rotation member 153a in a noncontact manner. Similarly, the movable element 15b moves in the -Y direction with the holes of the anti-rotation member 152b engaging with the slide member 451 in a noncontact manner. Interlocked with this, the slide member 451 also moves in the -Y direction. When the movable element 15b ends moving in the -Y direction, it starts moving in the +X direction. Interlocked with this, the support bar 45 also starts moving in the +X direction (indicated by arrows in Fig. 34). Note that the slide member 451 stops. At this time, the ridge 71 of the fixed bar 7 is at the lower position. When the ridge 71 of the fixed bar 7 moves upward to the upper position, it can engage with the anti-rotation member 154b in a noncontact manner.

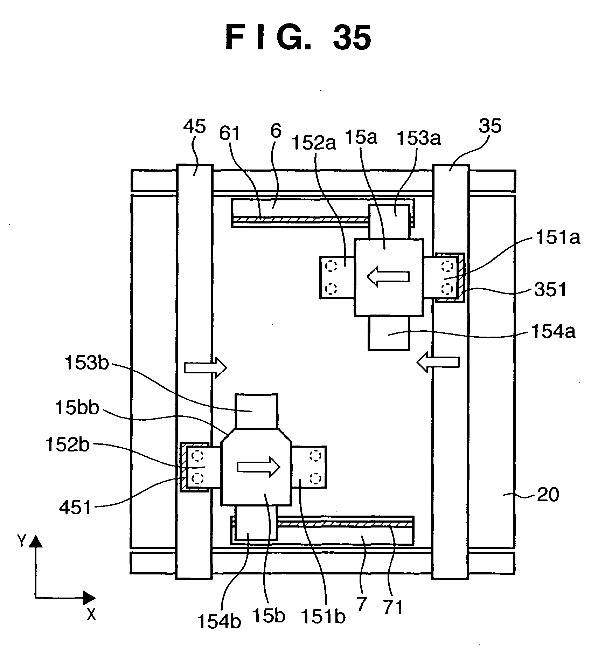

Subsequently, as shown in Fig. 35, the ridges 61 and 71 of the fixed bars 6 and 7 move upward, and respectively engage with the anti-rotation members 153a and 154b in a noncontact manner (the ridges of the fixed bars that have moved upward are hatched). In this state, the slide members 351 and 451 respectively engage with the anti-rotation members 151a and 152b.

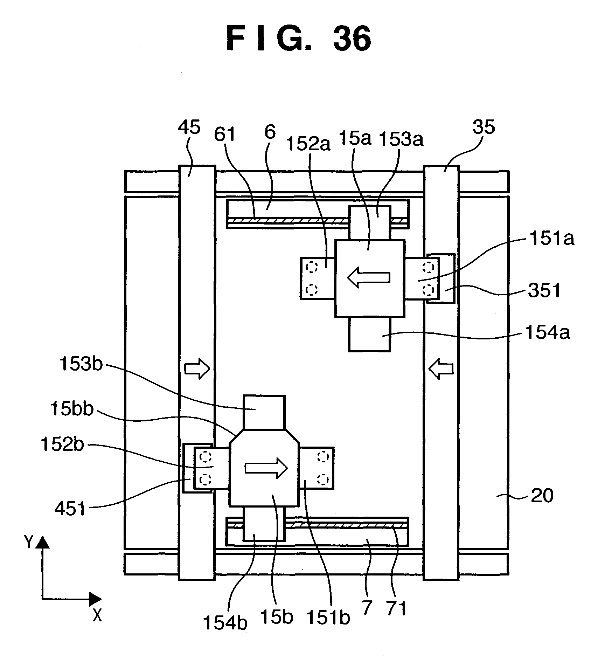

Subsequently, as shown in Fig. 36, the projections of the slide members 351 and 451 move downward to the lower positions. The support bars 35 and 45 respectively disengage from the movable elements 15a and 15b and are decelerated (deceleration is indicated by short arrows).

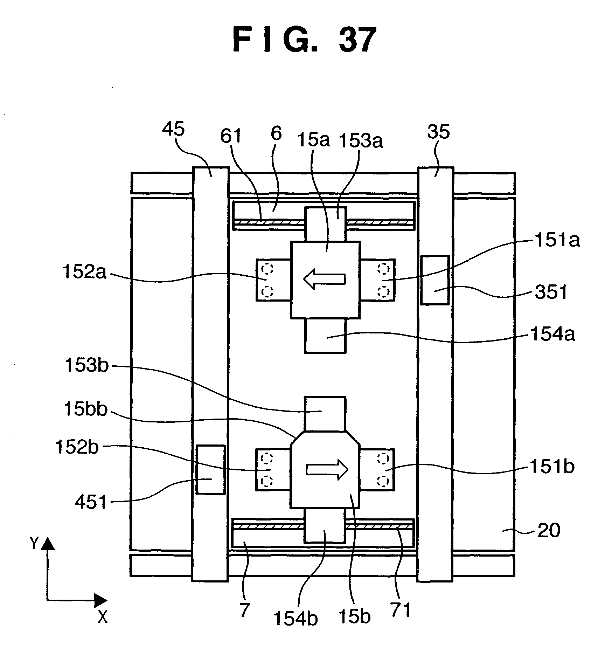

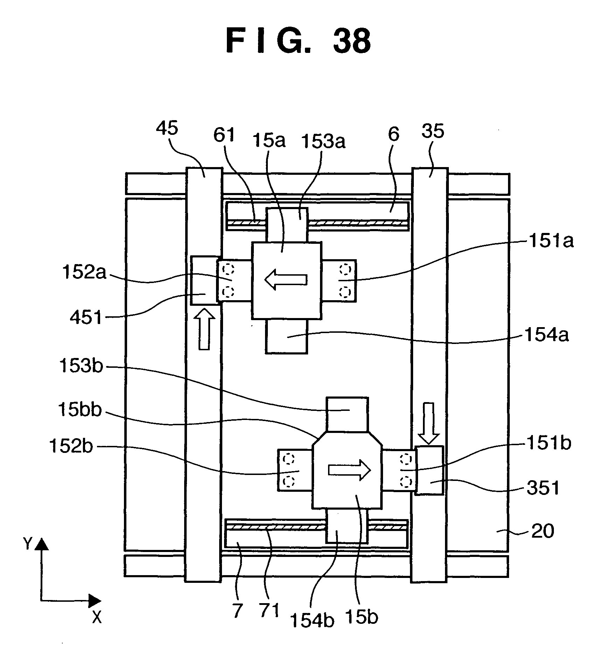

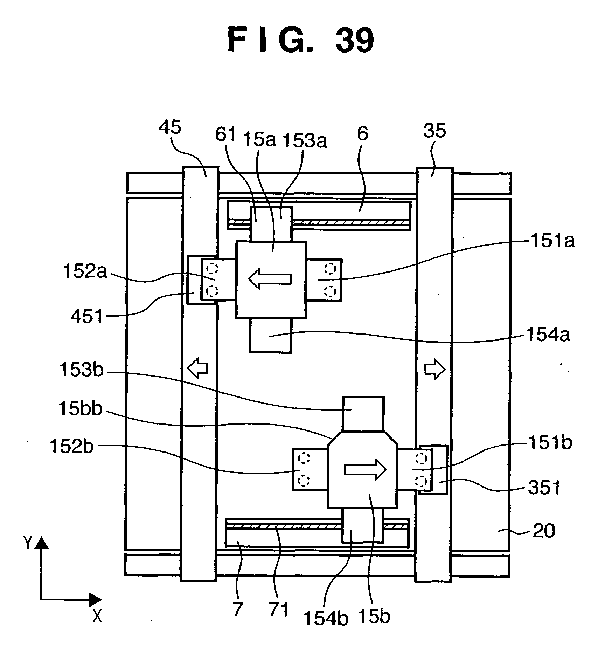

Subsequently, as shown in Fig. 37, the movable elements 15a and 15b enter a swap process area 501 and continuously move in the X direction, but the support bars 35 and 45 stop at predetermined positions. As shown in Fig. 38, the slide members 351 and 451 move in directions of arrows to swap the movable elements 15a and 15b. Subsequently, as shown in Fig. 39, when the slide members 351 and 451 move to predetermined positions, the support bars 35 and 45 start moving in directions of arrows (indicated as short arrows).

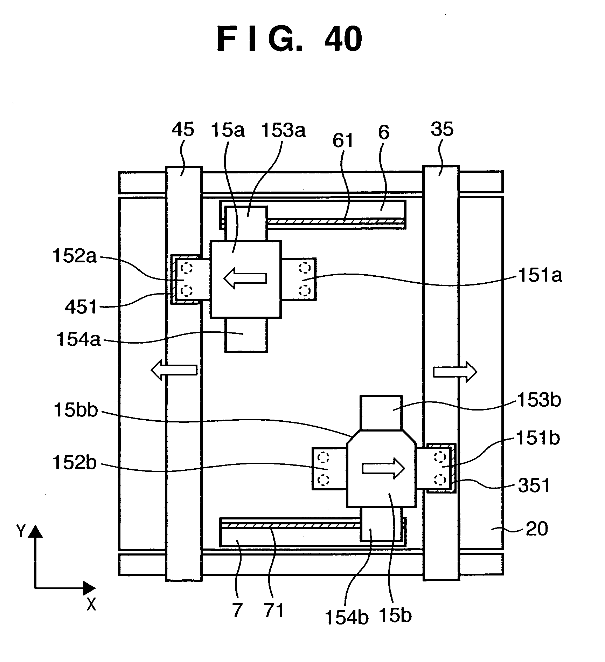

Subsequently, as shown in Fig. 40, the support bars 35 and 45 and the movable element 15b and 15a move in an interlocked manner. The projections of the slide members 351 and 451 move upward to the upper positions and respectively engage with the anti-rotation members 151b and 152a in a noncontact manner. Namely, the movable elements 15a and 15b swap. After this, the movable element 15a is to move together with the support bar 45, and the movable element 15b is to move together with the support bar 35.

The area where the position of the movable element can be regulated by the projections (regulating portions) formed on the slide member 351 which moves along the support bar 35 and the ridge (regulating portion) 61 formed on the fixed bar 6 is the first area, and the area where the position of the movable element can be regulated by the projections (regulating portions) formed on the slide member 451 which moves along the support bar 45 and the ridge (regulating portion) 71 formed on the fixed bar 7 is the second area. In other words, the position of the movable element located in the first area is regulated by the projections (regulating portions) formed on the slide member 351 which moves along the support bar 35 and the ridge (regulating portion) 61 formed on the fixed bar 6 so that the movable element will not deviate from the target position. The position of the movable element located in the second area is regulated by the projections (regulating portions) formed on the slide member 451 which moves along the support bar 45 and the ridge (regulating portion) 71 formed on the fixed bar 7 so that the movable element will not deviate from the target position.

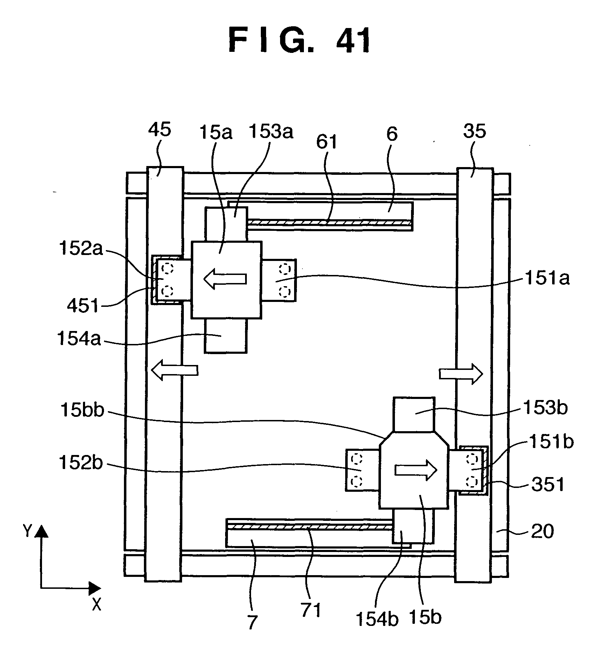

Fig. 41 shows a state wherein the movable element 15a has moved to the alignment process area 401 and the movable element 15b has moved to the exposure process area 301. The fixed bar ridges 61 and 71 have moved downward to the lower positions, so that the movable elements 15a and 15b can move in the -Y and +Y directions, respectively. The support bars 35 and 45 have also moved accordingly.

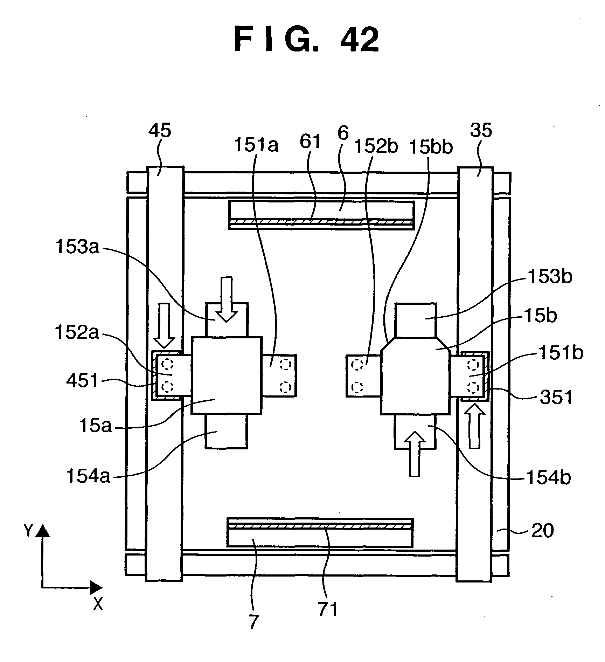

Subsequently, when the movable elements 15a and 15b and the slide members 351 and 451 move in directions of arrows as shown in Fig. 42, they are restored to the state of Fig. 31 (note that the movable elements have swapped).

In this manner, one cycle is ended. During this one cycle, when the movable elements move, the holes or recesses (engaging portions) of the anti-rotation members of the movable elements and the projections or ridges (regulating portions) of the slide members or support bars always engage with each other somewhere in a noncontact manner. According to this embodiment, in an uncontrollable run, when the power supply of the apparatus is turned off for emergency stop, the projections of the slide members and the ridges of the fixed bars move upward to the upper position to engage with the holes or recesses of the anti-rotation members. The postures of the movable elements will not be largely changed at any time because the movable elements run uncontrollably to lead to an uncontrollable error. When the power supply is to be turned on to restore the apparatus, if sensors that check whether or not the holes or recesses of the anti-rotation members and the projections of the slide members or the ridges of the fixed bars engage with each other are provided, even when they engage at a plurality of portions (when the power supply is turned off in the states of Figs. 35 and 40), which engagement is to be canceled for restoration can be specified. According to this embodiment, due to the presence of the fixed bars 6 and 7, the movement of the stages need not be stopped during swapping. Thus, the throughput can be further increased.

According to this embodiment, the support bars 35 and 45 are respectively provided with the slide members 351 and 451 which can move in the Y direction, and the fixed bars 6 and 7 are respectively provided with the ridges 61 and 71 which move only vertically. Alternatively, the ridges of the fixed bars may be of a type that can slide in the X direction, and the ridges of the support bars may be of a type that move only vertically.

### (Sixth Embodiment)

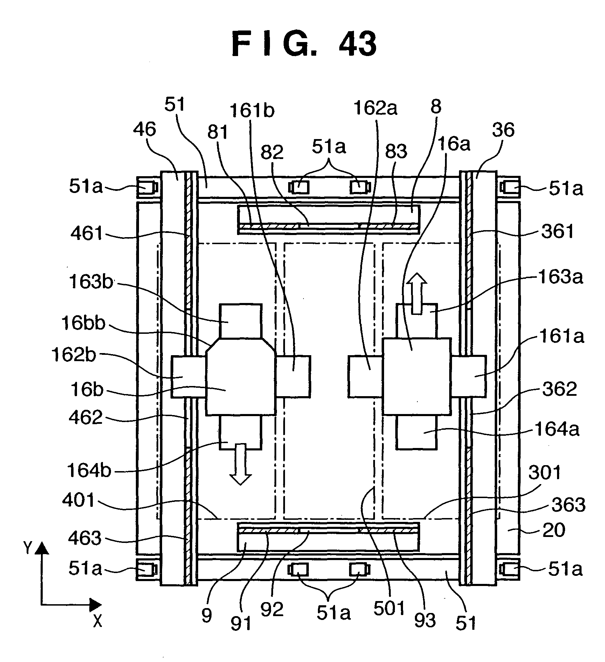

Figs. 43 to 51 are schematic plan views of a wafer stage device according to the sixth embodiment of the present invention, and show the movement of the stages at different steps sequentially. The wafer stage device has a stator 20 and two movable elements 16a and 16b. The stator 20 and movable element 16a form one plane motor, and the stator 20 and movable element 16b form the other plane motor. C-chamfered portions 16bb serving as identifiers are formed on the movable element 16b to identify the combinations of two movable elements and two support bars or fixed bars.

Anti-rotation members 161a, 162a, 163a, and 164a are provided to the side surfaces of the movable element 16a, and anti-rotation members 161b, 162b, 163b, and 164b are provided to the side surfaces of the movable element 16b. All the anti-rotation members have recesses (engaging portions) in the same manner as the anti-rotation member 121a of Fig. 16.

Support bars 36 and 46 are arranged such that they can be moved in the X direction by a driving mechanism (not shown) along guides 51. In this driving mechanism, for example, magnets can be provided to the support bars 36 and 46 to drive the support bars 36 and 46 by the interaction with the stator 20. Ridges (regulating portions) 361, 362, and 363, and 461, 462, and 463 are provided to the support bars 36 and 46, respectively. The ridges 361, 363, 461, and 463 can vertically move independently of each other with respect to the support bars. The ridges 362 and 462 are fixed at the upper positions.

The wafer stage device is further provided with fixed bars 8 and 9. The fixed bars 8 and 9 are respectively provided with ridges (regulating portions) 81, 82, and 83, and 91, 92, and 93. The ridges 81, 83, 91, and 93 can vertically move independently of each other with respect to the fixed bars. The ridges 82 and 92 are fixed at the upper positions.

The structure of the recesses of the anti-rotation members of the movable elements and the ridges of the support bars or fixed bars is identical to that shown in Fig. 16. Normally, the recesses of the anti-rotation members and the ridges of the support bars engage with each other in a noncontact manner. When the movable element runs uncontrollably due to some abnormalities, the recess of the anti-rotation member can come into contact with the support bar ridge to regulate the movement of the movable element.

When the recesses of the anti-rotation members of the movable elements engage with the support bar ridges, as the ridges of the support bars are regulated such that the support bars are not rotated by the guides 51, the rotation and X-direction translation of the movable elements can be regulated, but the support bars can translate freely in the Y direction. Thus, the end of each support bar preferably has a shape like that of the end 322a of Fig. 16, so that the support bars can serve as stoppers. Obviously, the stoppers are not limited to this structure, but, e.g., shock absorbers may be provided. Similarly, when the recesses of the anti-rotation members engage with the fixed bar ridges, the ridges of the fixed bars regulate the rotation and Y-axis translation of the movable elements, but the movable elements can translate freely in the Y direction. Thus, the end of each fixed bar preferably has a shape like that of the end 322a of Fig. 16, so that the fixed bars can serve as stoppers. In case the support bar 36 or 46 should run uncontrollably, e.g., shock absorbers 51a are preferably provided as the X-direction stoppers to the two ends in the X-direction stroke of each support bar, as shown in Fig. 43.

As described in the first embodiment with reference to Figs. 8 and 9, each of the anti-rotation members 161a, 162a, 163a, 164a, 161b, 162b, 163b, and 164b is preferably provided with stoppers or bearings at its two sides, so that the recess of the anti-rotation member and the support bar ridge or fixed bar ridge will not collide against or be dragged by each other.

The movement of the wafer stage device, particularly the movable elements (stages), support bars, and fixed bars will be described with reference to Figs. 43 to 51. In the state shown in Fig. 43, the wafer held on the movable element 16a including the stage by a vacuum chuck or the like has been exposed in an exposure process area 301, and the wafer on the movable element 16b including the stage has been alignment-adjusted in an alignment process area 401 in a parallel manner. The recess (engaging portion) of the anti-rotation member 161a engages with the support bar ridge (regulating portions) 362 in a noncontact manner, and the recess (engaging portion) of the anti-rotation member 162b engages with the support bar ridge (regulating portion) 462 in a noncontact manner. In Fig. 43, the hatched ridges (regulating portions) have moved upward to the upper positions. In this state, the two movable elements start swapping. First, in Fig. 43, the movable elements 16a and 16b start moving in directions of arrows.

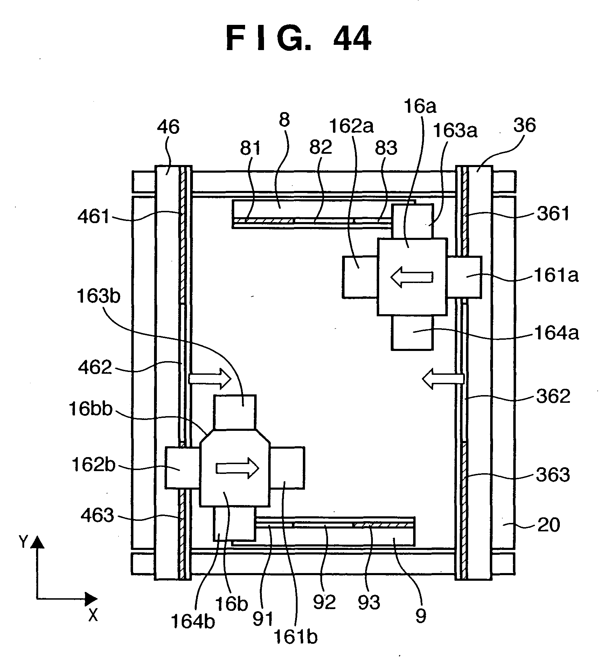

Subsequently, as shown in Fig. 44, the movable element 16a moves in the +Y direction with the recess of the anti-rotation member 161a engaging with the ridges 362 and 361 of the support bar 36 in a noncontact manner. When the movable element 16a ends moving in the +Y direction, it starts moving in the -X direction. Interlocked with this, the support bar 36 also starts moving in the -X direction (arrows in Fig. 44). At this time, the ridge 83 of the fixed bar 8 has moved downward to the lower position. When the ridge 83 of the fixed bar 8 moves upward to the upper position, it can engage with the anti-rotation member 163a in a noncontact manner. Similarly, the movable element 16b moves in the -Y direction with the recess of the anti-rotation member 162b engaging with the ridges 462 and 463 of the support bar 46 in a noncontact manner. When the movable element 16b ends moving in the -Y direction, it starts moving in the +X direction. Interlocked with this, the support bar 46 also starts moving in the +X direction (arrows in Fig. 44). At this time, the ridge 91 of the fixed bar 9 has moved downward to the lower position. When the ridge 91 of the fixed bar 9 moves upward to the upper position, it can engage with the anti-rotation member 164b in a noncontact manner.

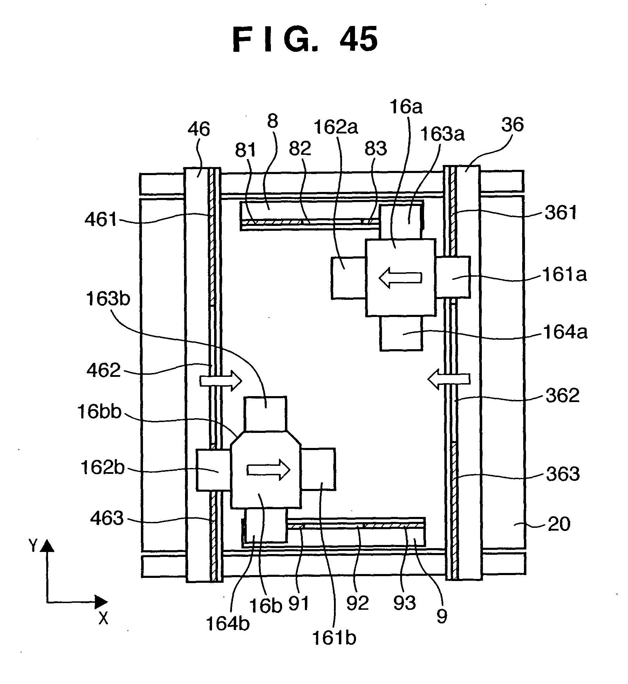

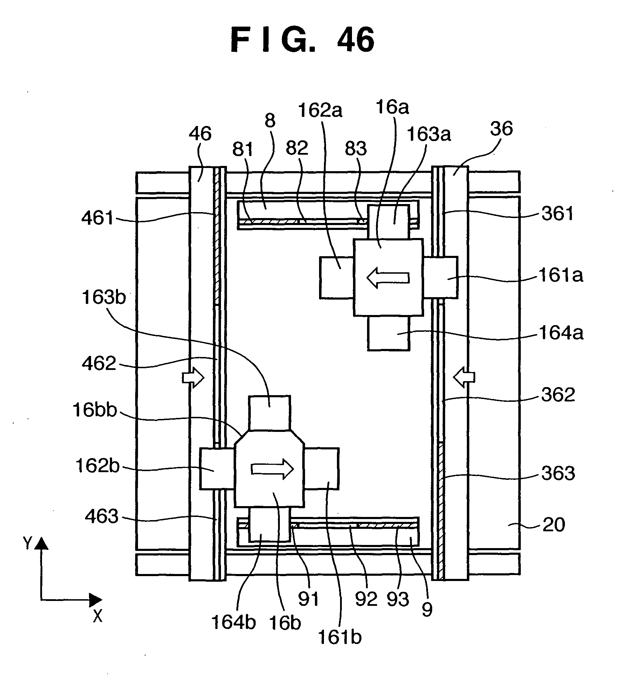

Subsequently, as shown in Fig. 45, the ridges 83 and 91 of the fixed bars 8 and 9 move upward to the upper positions, and respectively engage with the anti-rotation members 163a and 164b in a noncontact manner. In this state, the ridges 361 and 463 of the support bars 36 and 46 also respectively engage with the anti-rotation members 161a and 162b in a noncontact manner. Subsequently, as shown in Fig. 46, the ridges 361 and 463 of the supports bar 36 and 46 respectively move downward to the lower positions. The support bars 36 and 46 that engage with the movable elements 16a and 16b in a noncontact manner are disengaged from them and are decelerated (deceleration is indicated by short arrows).

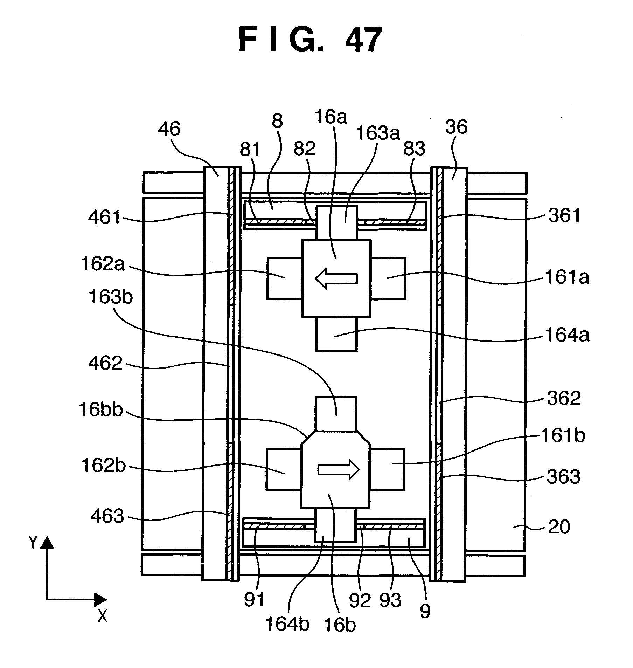

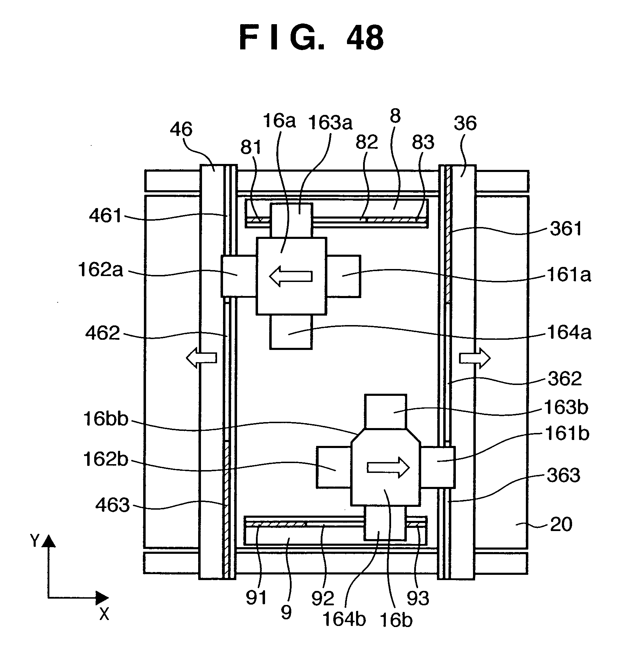

Subsequently, as shown in Fig. 47, the movable elements 16a and 16b enter a swap process area 501 and continuously move in the X direction, but the support bars 36 and 46 stop at predetermined positions (at this time, the ridges 361 and 463 of the support bars 36 and 46 have returned to the upper positions). Subsequently, as shown in Fig. 48, the support bars 36 and 46 start moving in directions of arrows (indicated by short arrows). At this time, the support bar ridges 363 and 461 have moved downward to the lower positions.

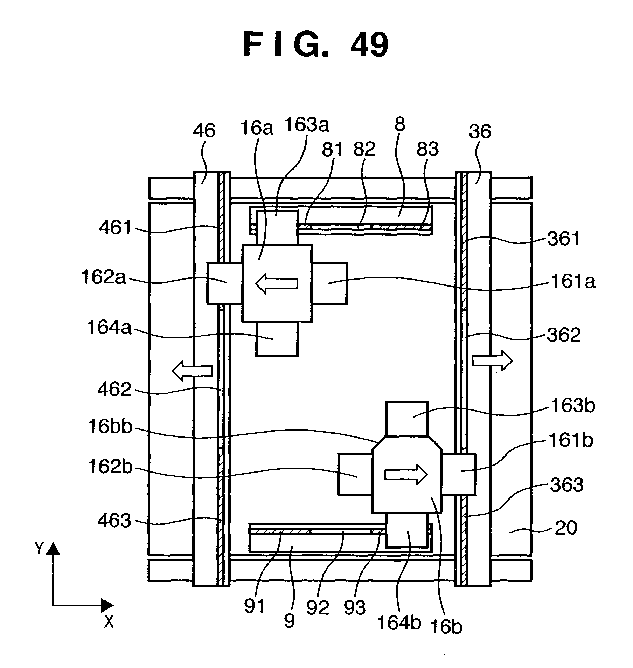

Subsequently, as shown in Fig. 49, the support bars 36 and 46 and the movable element 16a and 15b move in an interlocked manner. The support bar ridges 363 and 463 move upward to the upper positions and respectively engage with the anti-rotation members 161b and 162a in a noncontact manner. Namely, the movable elements 16a and 16b swap. After this, the movable element 16a is to move together with the support bar 46, and the movable element 16b is to move together with the support bar 36.

The area where the position of the movable element can be regulated by the ridges (regulating portions) 361, 362, and 363 formed on the support bar 36 and the ridges 81, 82, and 83 formed on the fixed bar 8 is the first area, and the area where the position of the movable element can be regulated by the ridges (regulating portions) 461, 462, and 463 formed on the support bar 46 and the ridges (regulating portions) 91, 92, and 93 formed on the fixed bar 9 is the second area. In other words, the position of the movable element located in the first area is regulated by the ridges (regulating portions) 361, 362, and 363 formed on the support bar 36 and the ridges 81, 82, and 83 formed on the fixed bar 8 so that the movable element will not deviate from the target position. The position of the movable element located in the second area is regulated by the ridges (regulating portions) 461, 462, and 463 formed on the support bar 46 and the ridges (regulating portions) 91, 92, and 93 formed on the fixed bar 9 so that the movable element will not deviate from the target position.

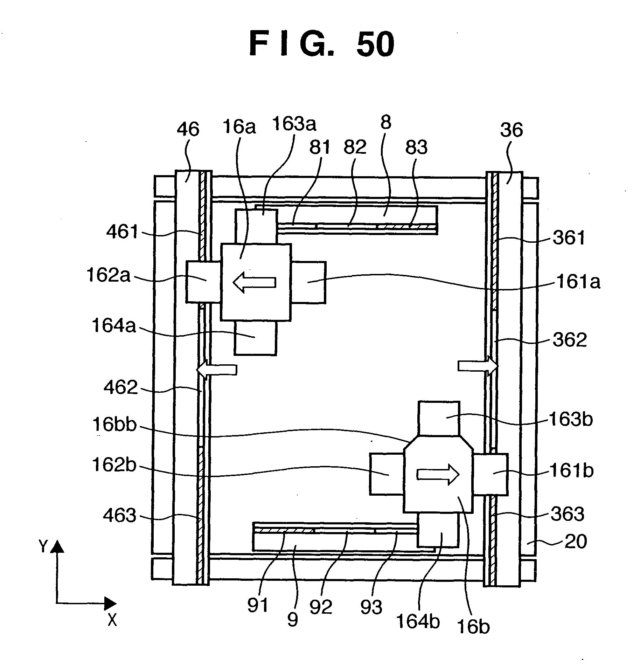

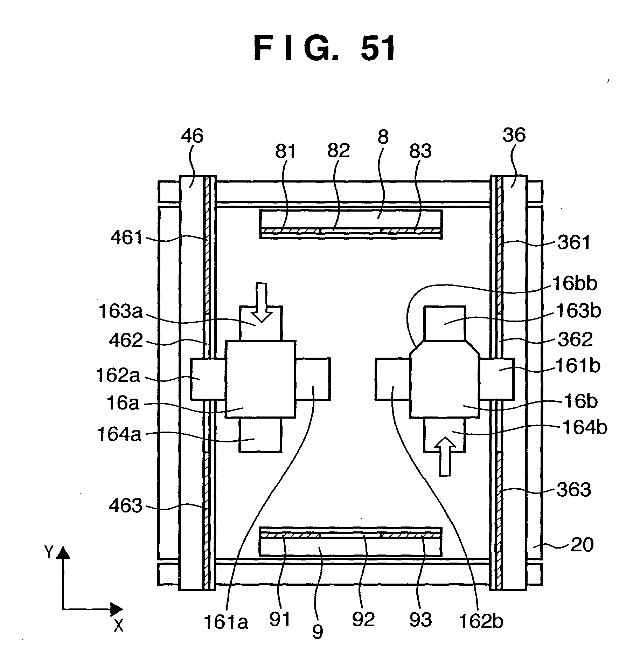

Fig. 50 shows a state wherein the movable element 16a has moved to the alignment process area 401 and the movable element 16b has moved to the exposure process area 301. The ridges 81 and 93 of the fixed bars 8 and 9 have moved downward to the lower positions, so that the movable elements 16a and 16b can move in the -Y and +Y directions, respectively. The support bars 36 and 46 have also moved accordingly. When the movable elements 16a and 16b move in directions of arrows as shown in Fig. 51, they are restored to the state of Fig. 33 (note that the movable elements have swapped).

In this manner, one cycle is ended. During this one cycle, when the movable elements move, the recesses (engaging portions) of the anti-rotation members of the movable elements and the ridges (regulating portions) of the support bars or fixed bars always engage with each other somewhere in a noncontact manner. According to this embodiment, in an uncontrollable run, when the power supply of the apparatus is turned off for emergency stop, the ridges of the support bars and the ridges of the fixed bars move upward to the upper positions to engage with the recesses of the anti-rotation members. The postures of the movable elements will not be largely changed at any time because the movable elements do not run uncontrollably to lead to an uncontrollable error. When the power supply is to be turned on to restore the apparatus, if sensors that check whether or not the recesses of the anti-rotation members and the ridges of the support bars or the ridges of the fixed bars engage with each other are provided, even when they engage at a plurality of portions (when the power supply is turned off in the states of Figs. 45 and 49), which engagement is to be canceled for restoration can be specified.

Although the engaging portions and regulating portions move vertically in the first to sixth embodiments, they are not limited to this type, but can move, e.g., to the left and right. In the first to sixth embodiments, the recesses are formed in the movable elements and the ridges are formed on the bars. Alternatively, ridges may be formed on the movable elements and recesses may be formed in the bars.

### (Application to Exposure Apparatus)

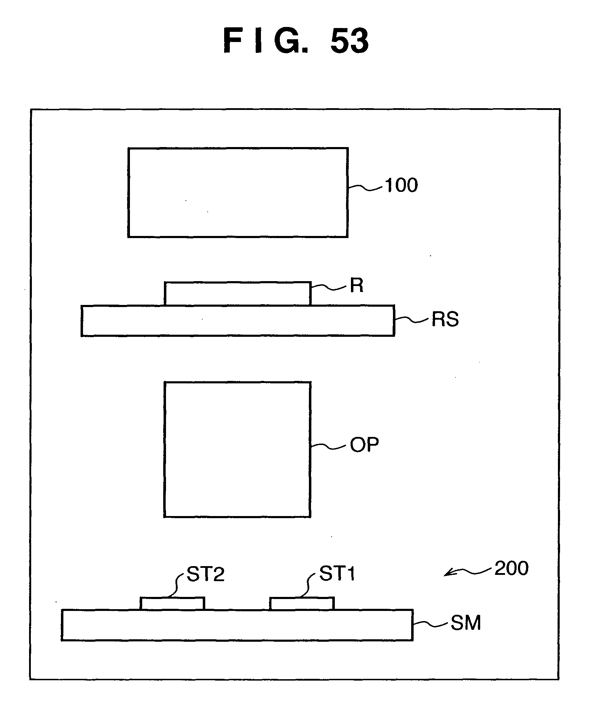

Fig. 53 is a view showing the schematic structure of an exposure apparatus to which a twin-stage wafer stage device represented by the above embodiments is applied. The exposure apparatus shown in Fig. 53 has a wafer stage device 200 represented by the above embodiments. The wafer stage device 200 has two stages (movable elements) ST1 and ST2 on a stator SM which has a planer portion. The stages ST1 and ST2 can be driven on the planer portion. The area where the stages ST1 and ST2 can move on the planer portion includes an exposure process area, an alignment process area, and a swap process area between the exposure process area and alignment process area. When one stage is used for exposure in the exposure process area, the other stage can be used for alignment in the alignment process area. The two stages ST1 and ST2 can swap in the swap process area. The positions of the two stages ST1 and ST2 are regulated by a regulating mechanism which can include the engaging portions and regulating portions as described above, so that the stages ST1 and ST2 will not deviate from target positions. In a normal state, the engaging portions and regulating portions do not engage with each other. The engaging portions and regulating portions come into contact with each other in an abnormal state wherein the stages ST1 and ST2 are to deviate from the target positions, to prevent deviation of the stages ST1 and ST2.

The pattern of a reticle (original) R held by a reticle stage RS is projected onto a wafer (substrate), which is held by a stage located within the exposure process area and coated with a photo sensitive agent, through an projection optical system OP, and a latent image pattern corresponding to the pattern of the reticle R is formed on the photo sensitive agent. The reticle R is illuminated by an illumination optical system 100.

In place of this structure, a scheme can be employed with which a latent image is formed on the photo sensitive agent while scanning the wafer with a charged-particle beam such as an electron beam.

### (Device Manufacturing Method)

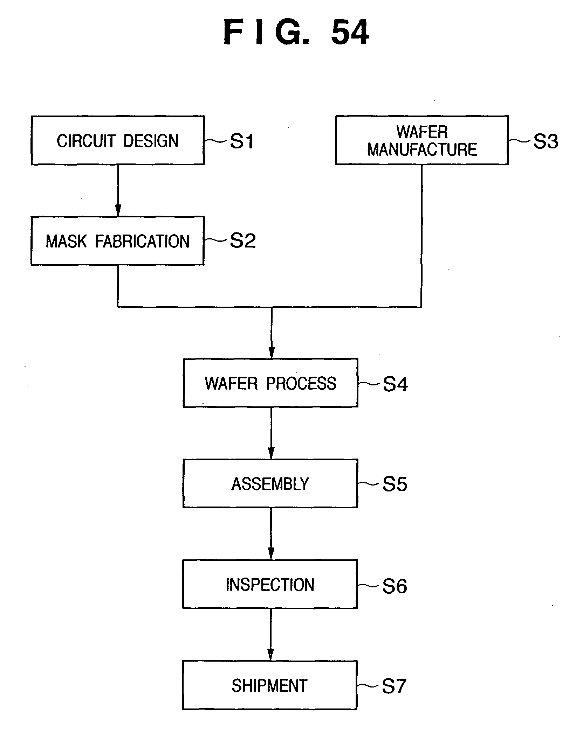

A semiconductor device manufacturing process which uses the above exposure apparatus will be described. Fig. 54 is a flowchart showing the flow of the entire semiconductor device manufacturing process. In step 1 (circuit design), the circuit of a semiconductor device is designed. In step 2 (mask fabrication), a mask is fabricated on the basis of the designed circuit pattern. In step 3 (wafer manufacture), a wafer is manufactured using a material such as silicon. In step 4 (wafer process) called a preprocess, an actual circuit is formed on the wafer in accordance with lithography using the mask and wafer described above. In the next step 5 (assembly) called a post-process, a semiconductor chip is formed from the wafer fabricated in step 4. This step includes processes such as assembly (dicing and bonding) and packaging (chip encapsulation). In step 6 (inspection), inspections including operation check test and durability test of the semiconductor device fabricated in step 5 are performed. A semiconductor device is finished with these steps and shipped (step 7).

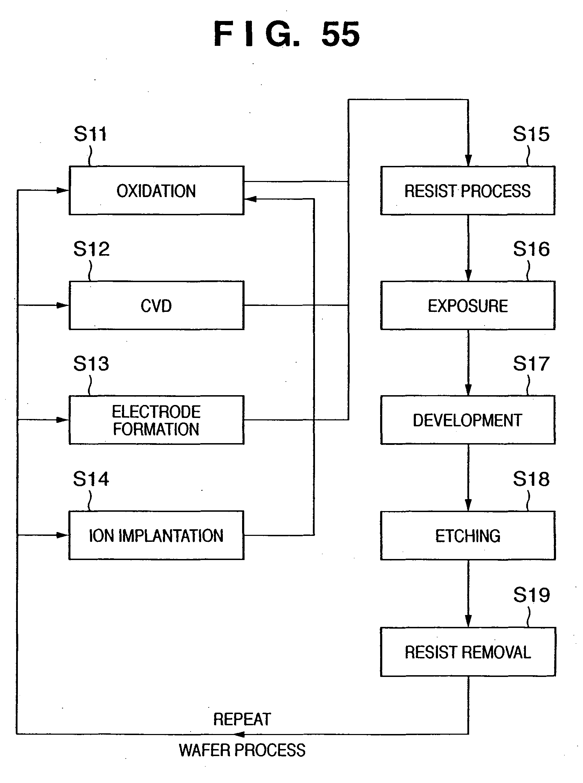

Fig. 55 is a flowchart showing the detailed flow of the wafer process. In step 11 (oxidation), the surface of the wafer is oxidized. In step 12 (CVD), an insulating film is formed on the wafer surface. In step 13 (electrode formation), an electrode is formed on the wafer by deposition. In step 14 (ion implantation), ions are implanted in the wafer. In step 15 (resist process), a photo sensitive agent is applied to the wafer. In step 16 (exposure), the latent image of the circuit pattern is formed on the photo sensitive agent on the wafer by the exposure apparatus described above. In step 17 (development), the exposed wafer is developed. In step 18 (etching), portions other than the developed resist image are removed. In step 19 (resist removal), any unnecessary resist after etching is removed. These steps are repeated to form multiple circuit patterns on the wafer.

As many apparently widely different embodiments of the present invention can be made without departing from the scope thereof, it is to be understood that the invention is not limited to the specific embodiments and covers, for example, all matter falling within the claims.

## Claims

1. An alignment apparatus comprising:
a stator which has a planer portion including first and second areas;
first and second movable elements which move on the planer portion; and
a regulating mechanism which regulates positions of the first and second movable elements, wherein
the first and second movable elements are driven to target positions by a force that acts among the first and second movable elements and stator, and
the regulating mechanism includes
a first regulator which regulates the position of, of the first and second movable elements, one which is located in the first area such that the movable element will not deviate from the target position, and
a second regulator which regulates the position of, of the first and second movable elements, one which is located in the second area such that the movable element will not deviate from the target position.

2. The apparatus according to claim 1, wherein the first and second areas partially overlap.

3. The apparatus according to claim 1, wherein the first and second regulators do not come into contact with the first and second movable elements while the first and second movable elements are located at the target positions.

4. The apparatus according to claim 1, wherein the first and second movable elements respectively include engaging portions, and deviation of the movable elements from the target positions is regulated by contact of the first or second regulators and the engaging portions.

5. The apparatus according to claim 4, wherein the regulating mechanism includes a driving mechanism which moves the engaging portions and/or the first and second regulators when the first and second movable elements are to be swapped between the first and second areas.

6. The apparatus according to claim 1, wherein the first and second movable elements respectively include at least first and second engaging portions, the position of the movable element which has been driven from the second area to the first area is regulated by the first engaging portion and first regulator, and the position of the movable element which has been driven from the first area to the second area is regulated by the second engaging portion and second regulator.

7. The apparatus according to claim 4, wherein the engaging portions include recesses, ridges, or holes.

8. The apparatus according to claim 1, wherein the first regulator is provided to a first support moving member which moves together with, of the first and second movable elements, one which is located in the first area, and the second regulator is provided to a second support moving member which moves together with, of the first and second movable elements, one which is located in the second area.

9. The apparatus according to claim 8, wherein the first and second support moving members can move in such directions that a distance between the first and second support moving members changes.

10. The apparatus according to claim 9, wherein the first and second regulators extend along longitudinal directions of the first and second support moving members, respectively, and the first and second support moving members stop when the first and second movable elements move along the longitudinal directions, and move in the longitudinal directions, when the first and second movable elements move along directions perpendicular to the longitudinal directions, together with the first and second movable elements.

11. The apparatus according to claim 9, wherein the first regulator can move in the longitudinal direction of the first support moving member together with the movable element located in the first area, and the second regulator can move along the longitudinal direction of the second support moving member together with the movable element located in the second area.

12. The apparatus according to claim 8, wherein the first and second support moving members have stoppers which regulate moving ranges of the first and second movable elements in the longitudinal directions.

13. The apparatus according to claim 8, further comprising a second stopper which regulates moving ranges of the first and second support moving members.

14. The apparatus according to claim 1, further comprising:
a first support moving member which is arranged to extend along a second direction perpendicular to a first direction and moves along the first direction together with, of the first and second movable elements, one which is located in the first area;
a second support moving member which is arranged to extend along the second direction and moves together with, of the first and second movable elements, one which is located in the second area;
a first fixed member which is arranged within the first area so as to extend along the first direction between the first and second support moving members; and
a second fixed member which is arranged within the second area so as to extend along the first direction between the first and second support moving members,
wherein the first regulator is provided to the first support moving member and first fixed member to regulate the position of the movable element in the first area, and the second regulator is provided to the second support moving member and second fixed member to regulate the position of the movable element in the second area.

15. The apparatus according to claim 4, wherein a portion through which the first and second regulators and the engaging portions can be in contact with each other is formed such that when the engaging portions come into contact with the first and second regulators, the engaging portions slide on the first and second regulators.

16. The apparatus according to claim 4, wherein the first and second regulators and the engaging portions come into contact with each other through rollers.

17. The apparatus according to claim 1, wherein each of the first and second regulators is divided into a plurality of pieces, the plurality of divisional pieces being driven independently of each other.

18. The apparatus according to claim 1, wherein the first and second regulators and the first and second movable elements are formed such that even when a power supply is turned off, the positions of the first and second movable elements are regulated by the first and second regulators.

19. The apparatus according to claim 1, wherein at least one of the first and second movable elements has an identifying unit for identifying the remaining one of the first and second movable elements.

20. The apparatus according to claim 1, further comprising a sensor which checks that the positions of the first and second movable elements are regulated by the first and second regulators.

21. The apparatus according to claim 1, wherein
in a first step, the first and second movable elements arranged on a line along a first direction are moved in opposite directions along a second direction perpendicular to the first direction,
subsequently, in a second step, the first and second movable elements are moved in opposite directions along the first direction, and
subsequently, in a third step, the first and second movable elements are moved in the opposite directions along the second direction so that the first and second movable elements are arranged on the line again,
thereby swapping the first and second movable elements.

22. The apparatus according to claim 21, further comprising first and second support moving members which extend in the second direction and oppose each other, the first and second regulators being provided to the first and second support moving members, respectively, wherein
in the first step, while the first and second support moving members are set still, the first and second movable elements are moved along the second direction while regulating the positions of the first and second movable elements by the first and second regulators,
in the second step, the first and second support moving members are moved along the first direction and the first and second movable elements are moved along the second direction while regulating the positions of the first and second movable elements by the first and second regulators, and
in the third step, while the first and second support moving members are set still, the first and second movable elements are moved along the second direction while regulating the positions of the first and second movable elements by the first and second regulators.

23. The apparatus according to claim 22, wherein in the second step, the first and second movable elements are moved along the first direction to positions where the first and second movable elements are arranged on a line along the second direction, and when the second step is to shift to the third step, the first and second regulators that are to regulate the positions of the first and second movable elements are swapped.

24. The apparatus according to claim 21, further comprising:
first and second support moving members which extend in the second direction and oppose each other; and
first and second fixed members arranged between the first and second support moving members along the first direction, wherein
the first regulator is provided to the first support moving member and first fixed member,
the second regulator is provided to the second support moving member and second fixed member,
in the first step, while the first and second support moving members are set still, the first and second movable elements are moved along the second direction while regulating the positions of the first and second movable elements by the first and second regulators provided to the first and second support moving members,
in the second step, the first and second support moving members are moved along the first direction, the first and second movable elements are moved along the first direction while regulating the positions of the first and second movable elements by the first and second regulators provided to the first and second support moving members, thereafter the first and second moving members are set still, and the first and second movable elements are moved along the first direction while regulating the positions of the first and second movable elements by the first and second regulators provided to the first and second fixed members, and
in the third step, while the first and second support moving members are set still, the first and second movable elements are moved along the second direction while regulating the positions of the first and second movable elements by the first and second regulators provided to the first and second support moving members.

25. An exposure apparatus for forming a latent image of a pattern on a photo sensitive agent on a substrate to which the photo sensitive agent has been applied, comprising:
an alignment apparatus which has first and second stages and holds and aligns substrates on the first and second stages; and
a pattern forming unit which forms a latent image pattern on the photo sensitive agent on the substrate held on, of the first and second stages, one which is located within an exposure process area,
the exposure apparatus comprising, as the alignment apparatus, an alignment apparatus according to claim 1, and the first and second movable elements including the first and second stages, respectively.

26. A device manufacturing method comprising:
a step of forming, by using an exposure apparatus according to claim 25, a latent image on a photo sensitive agent on a substrate to which the photo sensitive agent has been applied,
a step of developing the latent image pattern, and
a step of using at least a part of the substrate to make a device.

27. Stage apparatus, for use with exposure apparatus for exposing a substrate with a pattern of radiation, comprising:
a plurality of stages movable over a common stage support surface; and
first and second stage restraining means, each for interacting with a stage at a respective region of the stage support surface so as to restrain excessive or unwanted movement of the stage,
the first and second stage restraining means each being arranged to release a stage with which it is interacting, so as to allow the stage to move out of the respective region, and to begin to interact with another stage which moves into the respective region.
